# EUROPEAN PATENT APPLICATION

(11) **EP 4 401 156 A1**
(43) Date of publication of application: **17.07.2024**
(21) Application number: 23212605.2
(22) Date of filing: 28.11.2023
(51) Int. Cl.: H01L 33/00, H01L 33/06, H01L 33/44, H01L 33/18

(54) **LIGHT EMITTING ELEMENT, METHOD OF MANUFACTURING LIGHT EMITTING ELEMENT, DISPLAY DEVICE COMPRISING LIGHT EMITTING ELEMENT**

(30) Priority: 11.01.2023 KR 20230004232
(71) Applicant: Samsung Display Co., Ltd., Yongin-si, Gyeonggi-do 17113 (KR)
(72) Inventor: LIM, Sang Hyung, 17113 Yongin-si (KR); SHEEN, Mi Hyang, 17113 Yongin-si (KR)
(74) Representative: Marks & Clerk LLP

(57) **Abstract**

A method of manufacturing a light emitting element, comprising patterning a first base area of a growth base, forming semiconductor layers, and patterning a portion of a second base area of the growth base, different from the first base area. A resulting light emitting element, and a display device including such a light emitting element are included.

## Description

### BACKGROUND

### 1. Technical Field

Various embodiments of the disclosure relate to a light emitting element, a method of manufacturing the light emitting element, and a display device comprising the light emitting element.

### 2. Description of Related Art

Recently, as interest in information display increases, research and development on display devices is continuously conducted.

### SUMMARY

Various embodiments of the disclosure are directed to a light emitting element which is improved in emission efficiency and reliability, a method of manufacturing the light emitting element, and a display device including the light emitting element.

Furthermore, various embodiments of the disclosure are directed to a light emitting element capable of preventing a risk from occurring during a manufacturing process, a method of manufacturing the light emitting element, and a display device including the light emitting element.

An embodiment of the disclosure provides a method of manufacturing a light emitting element. The method includes patterning a first base area of a growth base, forming semiconductor layers, and patterning a portion of a second base area of the growth base, different from the first base area.

In an embodiment, the method may further include forming an insulating layer to be included in the light emitting element. The insulating layer and the growth base may include a same material.

In an embodiment, the growth base and the insulating layer may include at least one of aluminium oxide and a silicon-based material.

In an embodiment, the patterning the first base area may include forming a barrier layer and a mask on the growth base, and exposing the growth base from the mask. The first base area and a non-disposition area in which the mask is not disposed may overlap each other in a plan view.

In an embodiment, the patterning of the portion of the second base area may include removing the barrier layer.

In an embodiment, the patterning of the portion of the second base area may include forming the barrier layer on the insulating layer by allowing at least a portion of the barrier layer to remain.

In an embodiment, the patterning of the first base area may include forming a hole in the growth base. A shape of the hole may correspond to the shape of a semiconductor stack structure provided to form the light emitting element manufactured by the method.

In an embodiment, the hole may have a constant cross-sectional area in a longitudinal direction.

In an embodiment, the patterning of the first base area may include etching the growth base such that an inner side surface of the growth base that is defined by the hole has an inclined surface.

In an embodiment, the forming of the hole may include forming a first hole, forming a second hole, and forming a third hole. Each of the first hole, the second hole, and the third hole may have a uniform cross-sectional area. The cross-sectional area of the second hole may be greater than the cross-sectional area of the first hole. The cross-sectional area of the second hole may be less than the cross-sectional area of the third hole.

In an embodiment, the semiconductor layers may include a semiconductor stack structure including a first semiconductor layer, an active layer, and a second semiconductor layer. The forming of the semiconductor layers may include passivating an outer surface of the semiconductor stack structure.

In an embodiment, the semiconductor layers may include a semiconductor stack structure overlapping the first base area in a plan view and including a first semiconductor layer, an active layer, and a second semiconductor layer, and an upper semiconductor stack structure overlapping the second base area in a plan view and including a first upper semiconductor layer, an upper active layer, and a second upper semiconductor layer.

In an embodiment, the forming of the semiconductor layers may include forming an active layer including a well layer and a barrier layer. The forming of the active layer may include forming the active layer such that the well layer and the barrier layer include a quantum particle.

In an embodiment, the method may further include forming an electrode layer on the first base area and the second base area after the forming of the semiconductor layers.

In an embodiment, the patterning of the portion of the second base area may include etching a portion of the second base area without performing an etching process for the first base area.

In an embodiment, the etching of the portion of the second base area may include allowing at least a portion of the second base area to remain and be provided as an insulating layer.

In an embodiment, the semiconductor layers may include a first semiconductor layer, an active layer, and a second semiconductor layer. The active layer may include a quantum well structure including a quantum particle. An etching range in which etching the portion of the second base area is performed may not overlap the quantum particle in an etching direction.

An embodiment of the disclosure provides a light emitting element. The light emitting element includes a semiconductor stack structure including a first semiconductor layer, a second semiconductor layer, and an active layer disposed between the first semiconductor layer and the second semiconductor layer, and an insulating layer disposed on at least one side surface of the semiconductor stack structure. The insulating layer includes a crystalline structure.

In an embodiment, the active layer may include a three-dimensional quantum well structure including a quantum particle.

In an embodiment, the active layer may include a well layer and a barrier layer and may not include a defect corresponding to the size of the quantum particle.

In an embodiment, the insulating layer may include at least one of aluminium oxide and a silicon-based material.

In an embodiment, the light emitting element may further include a superlattice layer disposed between the first semiconductor layer and the active layer, and an electron blocking layer disposed between the active layer and the second semiconductor layer.

In an embodiment, the insulating layer may include an insulating protrusion protruding in a longitudinal direction of the light emitting element, and enclosing space on one end of the semiconductor stack structure.

In an embodiment, the light emitting element may further include a barrier layer disposed on the insulating layer and including a conductive material.

In an embodiment, the light emitting element may include a first end adjacent to the first semiconductor layer, and a second end adjacent to the second semiconductor layer. A thickness of the insulating layer may be reduced from the first end toward the second end, and a cross-sectional area of the semiconductor stack structure may be increased from the first end toward the second end.

In an embodiment, the thickness of the insulating layer may be formed complementary to the cross-sectional area of the semiconductor stack structure, so that a cross-sectional area of the light emitting element may be uniform in a longitudinal direction of the light emitting element.

In an embodiment, each of the active layer, the first semiconductor layer, and the second semiconductor layer may have a cross-sectional area, the cross-sectional area of the active layer may be greater than the cross-sectional area of the first semiconductor layer, and the cross-sectional area of the active layer may be less than the cross-sectional area of the second semiconductor layer.

In an embodiment, the active layer may include a first active surface facing the first semiconductor layer, and a second active surface facing the second semiconductor layer. The first active surface may include a contact area which contacts the first semiconductor layer, and a non-contact area which does not contact the first semiconductor layer.

In an embodiment, the second active surface may entirely contact the second semiconductor layer.

In an embodiment, the insulating layer may include a first insulating layer including a crystalline structure and disposed on a side surface of the semiconductor stack structure, and a second insulating layer including an amorphous structure and disposed on a first end of the semiconductor stack structure.

An embodiment of the disclosure provides a display device including a light emitting element according to the disclosure.

An embodiment of the disclosure provides a method of manufacturing a light emitting element. The method includes patterning a first base area of a growth base, the growth base including the first base area and a second base area, forming semiconductor layers including a semiconductor stack structure and an upper semiconductor stack structure, forming an upper insulating layer, separating the upper semiconductor stack structure that overlaps the second base area in a plan view, patterning the second base area of the growth base, and separating the semiconductor stack structure that overlaps the first base area in a plan view to provide the light emitting element.

In an embodiment, the method may further include forming an insulating layer to be included in the light emitting element provided by performing the separating of the semiconductor stack structure. The insulating layer and the growth base may include a same material. The patterning of the first base area may include forming holes in the growth base. A shape of each of the holes may correspond to the shape of the light emitting element.

In an embodiment, the upper semiconductor stack structure may overlap the second base area in a plan view. The semiconductor stack structure may overlap the first base area in a plan view.

In an embodiment, the upper insulating layer may include an outer insulating layer covering a side surface of the upper semiconductor stack structure, and an inner insulating layer disposed on at least one surface of the semiconductor stack structure.

In an embodiment, the upper insulating layer may include an amorphous structure.

In an embodiment, the method may further include etching the upper semiconductor stack structure after the forming of the semiconductor layers.

In an embodiment, the separating of the semiconductor stack structure may include providing a first light emitting element. The separating of the upper semiconductor stack structure may include providing a second light emitting element.

In an embodiment, the size of the first light emitting element is less than the size of the second light emitting element.

At least some of the above and other features of the invention are set out in the claims.

### BRIEF DESCRIPTION OF THE DRAWINGS

FIGS. 1 to 3 are schematic views each illustrating a light emitting element in accordance with a first embodiment.
FIGS. 4 and 5 are schematic views each illustrating a light emitting element in accordance with a second embodiment.
FIG. 6 is a schematic view illustrating a light emitting element in accordance with a third embodiment.
FIG. 7 is a schematic view illustrating a light emitting element in accordance with a fourth embodiment.
FIG. 8 is a schematic view illustrating a light emitting element in accordance with a fifth embodiment.
FIG. 9 is a schematic view illustrating a light emitting element in accordance with a sixth embodiment.
FIG. 10 is a schematic view illustrating a light emitting element in accordance with a seventh embodiment.
FIG. 11 is a schematic plan view illustrating a display device in accordance with an embodiment.
FIG. 12 is a schematic plan view illustrating a sub-pixel in accordance with an embodiment.
FIG. 13 is a schematic sectional view taken along line A-A' of FIG. 12.
FIG. 14 is a schematic sectional view illustrating a display device in accordance with an embodiment.
FIG. 15 is a schematic sectional view illustrating a display device in accordance with an embodiment.
FIG. 16 is a schematic sectional view illustrating a pixel in accordance with an embodiment.
FIGS. 17 to 40 are views illustrating methods of manufacturing light emitting elements in accordance with the first to sixth embodiments.
FIGS. 41 to 48 are views illustrating a method of manufacturing light emitting elements in accordance with the seventh embodiment.
FIG. 49 is a schematic view for comparing sizes of a first light emitting element and a second light emitting element to each other in accordance with an embodiment.

### DETAILED DESCRIPTION OF THE EMBODIMENTS

As the disclosure allows for various changes and numerous embodiments, only a few particular embodiments will be illustrated in the drawings and described in detail in the written description. However, this is not intended to limit the disclosure to particular modes of practice, and it is to be appreciated that all changes, equivalents, and substitutes that do not depart from the technical scope of the disclosure are encompassed in the disclosure.

It will be understood that, although the terms "first", "second", etc. may be used herein to describe various elements, these elements should not be limited by these terms. These terms are only used to distinguish one element from another element. For instance, a first element discussed below could be termed a second element without departing from the teachings of the disclosure. Similarly, the second element could also be termed the first element.

In the disclosure, the singular forms are intended to comprise the plural forms as well, unless the context clearly indicates otherwise.

In the specification and the claims, the term "and/or" is intended to include any combination of the terms "and" and "or" for the purpose of its meaning and interpretation. For example, "A and/or B" may be understood to mean any combination including "A, B, or A and B." The terms "and" and "or" may be used in the conjunctive or disjunctive sense and may be understood to be equivalent to "and/or."

For the purposes of this disclosure, the phrase "at least one of A and B" may be construed as A only, B only, or any combination of A and B. Also, "at least one of X, Y, and Z" and "at least one selected from the group consisting of X, Y, and Z" may be construed as X only, Y only, Z only, or any combination of two or more of X, Y, and Z.

The terms "overlap" or "overlapped" mean that a first object may be above or below or to a side of a second object, and vice versa. Additionally, the term "overlap" may include layer, stack, face or facing, extending over, covering, or partly covering or any other suitable term as would be appreciated and understood by those of ordinary skill in the art.

When an element is described as "not overlapping" or to "not overlap" another element, this may include that the elements are spaced apart from each other, offset from each other, or set aside from each other or any other suitable term as would be appreciated and understood by those of ordinary skill in the art.

"About" or "approximately" or "substantially" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" may mean within one or more standard deviations, or within ± 30%, 20%, 10%, 5% of the stated value.

It will be further understood that the terms "comprise", "include", "have", etc. when used in the disclosure, specify the presence of stated features, integers, steps, operations, elements, components, and/or combinations of them but do not preclude the presence or addition of one or more other features, integers, steps, operations, elements, components, and/or combinations thereof.

Furthermore, in the case that a first part such as a layer, a film, a region, or a plate is disposed on a second part, the first part may be not only directly on the second part but a third part may intervene between them. In addition, when it is expressed that a first part such as a layer, a film, a region, or a plate is formed on a second part, the surface of the second part on which the first part is formed is not limited to an upper surface of the second part but may comprise other surfaces such as a side surface or a lower surface of the second part. In the case that a first part such as a layer, a film, a region, or a plate is under a second part, the first part may be not only directly under the second part but a third part may intervene between them.

Various embodiments of the disclosure relate to a light emitting element, a method of manufacturing the light emitting element, and a display device comprising the light emitting element. Hereinafter, the light emitting element, the method of manufacturing the light emitting element, and the display device comprising the light emitting element in accordance with an embodiment will be described with reference to the attached drawings.

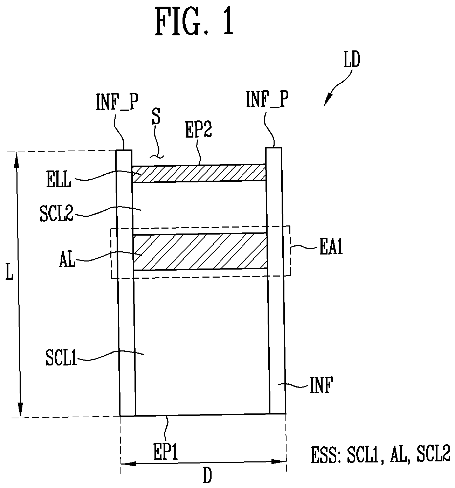

A light emitting element LD in accordance with each of one or more embodiments will be described with reference to FIGS. 1 to 10.

First, a light emitting element LD in accordance with a first embodiment will be described with reference to FIGS. 1 to 3.

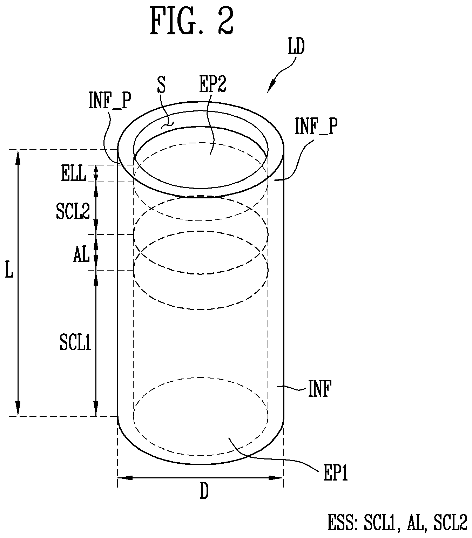

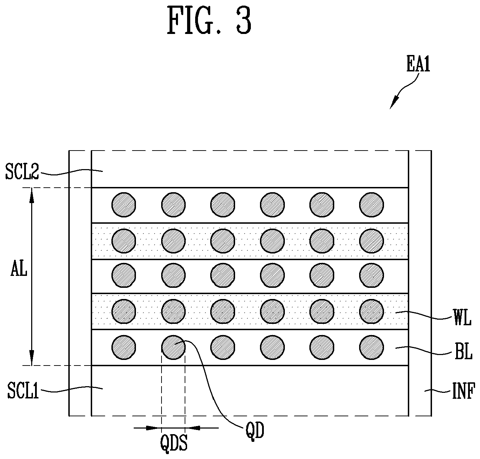

FIGS. 1 to 3 are schematic views each illustrating the light emitting element in accordance with the first embodiment. FIG. 1 is a schematic sectional view illustrating the light emitting element LD in accordance with the first embodiment. FIG. 2 is a schematic perspective view illustrating the light emitting element LD in accordance with the first embodiment. FIG. 3 is a schematic enlarged view of area EA1 of FIG. 1.

The light emitting element LD is configured to emit light. The light emitting element LD includes a semiconductor stack structure ESS and an insulating layer INF. The semiconductor stack structure ESS includes a first semiconductor layer SCL1, a second semiconductor layer SCL2, and an active layer AL disposed between the first semiconductor layer SCL1 and the second semiconductor layer SCL2. In an embodiment, the light emitting element LD may further include an electrode layer ELL.

In an embodiment, the first semiconductor layer SCL1, the active layer AL, and the second semiconductor layer SCL2 may be successively stacked on each other in a longitudinal direction (L) of the light emitting element LD. In the specification, the longitudinal direction (L) may be a direction in which the layers of the semiconductor stack structure ESS are stacked on each other.

The light emitting element LD may have various shapes. For example, the light emitting element LD may have a pillar-like shape extending in a direction (e.g., the longitudinal direction (L)). The cross-sectional area of the light emitting element LD in accordance with the first embodiment may be substantially uniform in the longitudinal direction (L). For example, the cross-sectional area of the second semiconductor layer SCL2, the cross-sectional area of the active layer AL, and the cross-sectional area of the first semiconductor layer SCL1 may be substantially similar to each other.

The light emitting element LD may include a first end EP1 and a second end EP2. The semiconductor stack structure ESS may include a first end EP1 and a second end EP2. In an embodiment, the first semiconductor layer SCL1 may be adjacent to the first end EP1 of the light emitting element LD, and the second semiconductor layer SCL2 may be adjacent to the second end EP2 of the light emitting element LD. In an embodiment, the electrode layer ELL may be adjacent to the second end EP2. In an embodiment, an insulating protrusion INF_P of the insulating layer INF may be adjacent to the second end EP2.

The light emitting element LD may have various sizes. In an embodiment, a diameter D (or a width) of the light emitting element LD and the length L of the light emitting element LD each may range from the nanoscale to the microscale. However, the disclosure is not limited thereto.

The first semiconductor layer SCL1 may include a first conductive semiconductor. The first semiconductor layer SCL1 may be disposed on the active layer AL and include a semiconductor layer having a type different from that of the second semiconductor layer SCL2. For example, the first semiconductor layer SCL1 may include an N-type semiconductor layer. For example, the first semiconductor layer SCL1 may include one or more selected from the group consisting of InAlGaN, GaN, AlGaN, InGaN, AlN, and InN, and may include an N-type semiconductor layer doped with a first conductive dopant such as Si, Ge, and/or Sn. However, the disclosure is not limited to the foregoing example. The first semiconductor layer SCL1 may include various materials.

The active layer AL may be disposed between the first semiconductor layer SCL1 and the second semiconductor layer SCL2. The position of the active layer AL may be changed in various ways depending on the type of the light emitting element LD, rather than being limited to a specific example.

The active layer AL may include a single-quantum well structure or a multi-quantum well structure.

The active layer AL may include a well layer WL and a barrier layer BL. The barrier layer BL may form a quantum barrier for forming the quantum well structure. The well layer WL may form a quantum well for forming the quantum well structure. For example, the barrier layer BL may include GaN, and the well layer WL may include InGaN. However, the disclosure is not limited to the foregoing.

In an embodiment, the active layer AL may have a three-dimensional quantum well structure. For example, the active layer AL may further include a quantum particle QD. For example, the barrier layer BL may include a quantum particle QD, and the well layer WL may include a quantum particle QD. The quantum particle QD may enhance a recombination rate between electrons and holes, so that the emission efficiency of the light emitting element LD may be improved.

In an embodiment, the quantum particle QD may include various materials. In an embodiment, the quantum particle QD may include InGaN. For example, InGaN for forming the quantum particle QD may have a composition of InₓGa₁₋ₓN. In an embodiment, In may be contained in InₓGa₁₋ₓN at a percentage ranging from 10 at% (atomic percent) to 30 at%. However, the disclosure is not limited to the foregoing.

The quantum particle QD may have a quantum diameter QDS. Here, the quantum diameter QDS may mean the largest diameter defined in the quantum particle QD. For example, in the case where the quantum particle QD is a spherical shape, the quantum diameter QDS may be the diameter of the sphere. In the case where the quantum particle QD is an elliptical shape, the quantum diameter QDS may be the length of the long axis of the ellipse. In the case where the quantum particle QD has an irregular shape, the quantum diameter QDS may mean the longest diameter defined in the quantum particle QD. For example, a separation distance may be defined between a first point and a second point which are peripheral points in the quantum particle QD. The quantum diameter QDS may mean the largest value among separation distances.

In an embodiment, the quantum diameter QDS may range from 0.5 nm to 10 nm. In an embodiment, the quantum diameter QDS may range from 1 nm to 5 nm. In an embodiment, the quantum diameter QDS may be less than the diameter D of the active layer AL. In an embodiment, the diameter D may range from 0.5 nm to 1000 nm. In an embodiment, the diameter D may range from 1 nm to 500 nm. However, the disclosure is not limited to the foregoing.

In an embodiment, the active layer AL may not include a defect. For example, the active layer AL may not include a defect of a size corresponding to the quantum diameter QDS. In an embodiment, while the light emitting element LD is manufactured, an etching process for the active layer AL including the quantum particle QD may not be performed. For example, an etching process for patterning the active layer AL may not be performed. Hence, a risk of damage to the quantum particle QD during the etching process can be prevented from occurring.

Experimentally, in the case where the quantum particle QD is damaged by the etching process, space in which the quantum particle QD has been disposed may be provided as a defect. However, in an embodiment, because the light emitting element LD may be manufactured without performing the etching process for the active layer AL, a defect can be prevented from occurring in the light emitting element LD, so that the emission efficiency of the light emitting element LD may be improved.

A cladding layer doped with a conductive dopant may be formed on a first side and a second side of the active layer AL. For example, the cladding layer may include one or more of AlGaN and InAlGaN. However, the disclosure is not limited to the foregoing example.

The second semiconductor layer SCL2 may include a second conductive semiconductor. The second semiconductor layer SCL2 may be disposed on the active layer AL and include a semiconductor layer of a type different from that of the first semiconductor layer SCL1. For example, the second semiconductor layer SCL2 may include a P-type semiconductor layer. For example, the second semiconductor layer SCL2 may include one or more semiconductor materials selected from the group consisting of InAlGaN, GaN, AlGaN, InGaN, AlN, and InN, and may include a P-type semiconductor layer doped with a second conductive dopant such as Ga, B, and/or Mg. However, the disclosure is not limited to the foregoing example. The second semiconductor layer SCL2 may include various materials.

In the case where a voltage of a threshold voltage or more is applied between the first end EP1 and the second end EP2 of the light emitting element LD, an electron-hole pair in the active layer AL may be recombined, and the light emitting element LD may emit light. Since light emission of the light emitting element LD can be controlled based on the foregoing principle, the light emitting element LD may be used as a light source in various devices.

The insulating layer INF may be disposed on a side surface of the semiconductor stack structure ESS. The insulating layer INF may enclose at least a portion of an outer surface of the active layer AL (e.g., a side surface of the active layer AL that is not covered with the first semiconductor layer SCL1 and the second semiconductor layer SCL2), and may further enclose a portion of each of the first semiconductor layer SCL1 and the second semiconductor layer SCL2.

In the specification, the term "side surface" may mean an area of an object (e.g., the semiconductor stack structure ESS, the active layer AL, the first semiconductor layer SCL1, the second semiconductor layer SCL2, or the like) including a portion of a remaining area except an upper surface and a lower surface of the object. Here, the upper surface and the lower surface of the object may mean surfaces corresponding to the first end EP1 or the second end EP2 of the light emitting element LD (or the semiconductor stack structure ESS). In an embodiment, the side surface may mean a portion of the outer surface of the object that is defined in an area between the first end EP1 and the second end EP2 of the light emitting element LD (or the semiconductor stack structure ESS).

The insulating layer INF may allow the first end EP1 and the second end EP2 of the light emitting element LD that have different polarities to be exposed. For example, the insulating layer INF allows respective ends of the electrode layer ELL and the first semiconductor layer SCL1 that are adjacent to the first end EP1 and the second end EP2 of the light emitting element LD to be exposed.

The insulating layer INF may secure electrical stability of the light emitting element LD. Furthermore, the insulating layer INF may minimize surface defects of the light emitting elements LD so that the lifetime and the efficiency of the light emitting element LD can be enhanced. In the case that multiple light emitting elements LD are disposed adjacent to each other, the insulating layer INF may prevent a short-circuit defect between the light emitting elements LD from occurring.

The insulating layer INF may include inorganic material. For example, the insulating layer INF may include aluminium oxide (AlₓO_{y}). In an embodiment, the insulating layer INF may include silicon-based material. For example, the silicon-based material may be silicon oxide (SiOₓ).

In an embodiment, the insulating layer INF may include inorganic material including a crystalline structure. The insulating layer INF may include material the same as material for forming a growth base GS provided to grow the light emitting element LD.

For example, in the case where the growth base GS includes aluminium oxide (AlₓO_{y}) as a sapphire substrate, the insulating layer INF may include aluminium oxide (AlₓO_{y}). In other embodiments, in the case where the growth base GS is formed of a silicon substrate (e.g., including silicon (Si) or silicon carbide (SiC)), the insulating layer INF may include silicon-based material.

The foregoing comes from the fact that the insulating layer INF of the light emitting element LD may be manufactured by patterning the growth base GS, and a detailed description thereof will be made below.

The insulating layer INF may include an insulating protrusion INF_P. The insulating protrusion INF_P may be a portion of the insulating layer INF that protrudes farther than the electrode layer ELL in a direction (e.g., in the longitudinal direction (L) of the light emitting element LD}. The insulating protrusion INF_P may be disposed along a peripheral line of a surface of the light emitting element LD that corresponds to the second end EP2. For example, as the insulating protrusion INF_P is formed, space S may be formed on the electrode layer ELL in an area enclosed by the insulating protrusion INF_P.

In an embodiment, the insulating protrusion INF_P may be disposed to protrude farther than the electrode layer ELL and the semiconductor stack structure ESS, so that the electrode layer ELL and the semiconductor stack structure ESS can be more efficiently protected from an external influence.

The electrode layer ELL may be disposed on the second semiconductor layer SCL2. The electrode layer ELL may be adjacent to the second end EP2. The electrode layer ELL may be directly adjacent to the space S formed by the insulating protrusion INF_P.

The electrode layer ELL may be electrically connected to the second semiconductor layer SCL2. A portion of the electrode layer ELL may be exposed. For example, the insulating layer INF allows a surface of the electrode layer ELL to be exposed. The electrode layer ELL may be exposed in an area corresponding to the first end EP1. In an embodiment, a side surface of the electrode layer ELL may be exposed.

In an embodiment, the electrode layer ELL may be an ohmic contact electrode. However, the disclosure is not limited to the foregoing example. For example, the electrode layer ELL may be a Schottky contact electrode.

In an embodiment, the electrode layer ELL may include one or more selected from the group consisting of chromium (Cr), titanium (Ti), aluminium (Al), gold (Au), and nickel (Ni). However, the disclosure is not limited to the foregoing example. In an embodiment, the electrode layer ELL may be substantially transparent. For example, the electrode layer ELL may include indium tin oxide (ITO). Hence, the electrode layer ELL allows emitted light to pass therethrough.

The structure of the light emitting element LD in accordance with an embodiment is not limited to the foregoing example. For example, the light emitting element LD may include a superlattice layer disposed between the first semiconductor layer SCL1 and the active layer AL, and/or an electron blocking layer disposed between the active layer AL and the second semiconductor layer SCL2.

In an embodiment, the superlattice layer may have a structure formed by alternately stacking two or more kinds of layers having different compositions. For example, the superlattice layer may have a structure in which GaN layers and InGaN layers are alternately stacked on each other. In an embodiment, the superlattice layer may relieve stress between the first semiconductor layer SCL1 and the active layer AL. The electron blocking layer may block at least a portion of a flow of electrons between the active layer AL and the second semiconductor layer SCL2 so that the efficiency of recombination of electron-hole pairs for light emission can be enhanced.

In an embodiment, the electron blocking layer may include material having energy band-gap larger than that of the second semiconductor layer SCL2 so as to prevent an overflow of electrons. For example, the electron blocking layer may include AlGaN doped with Mg.

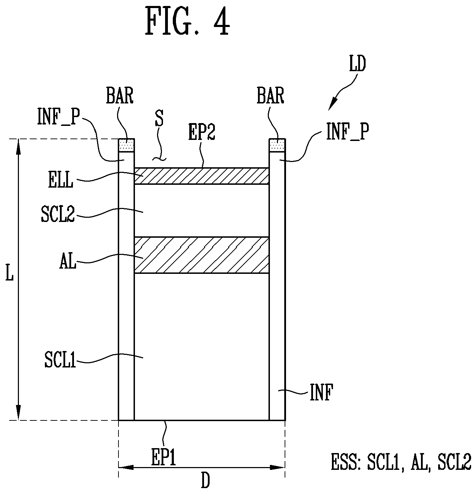

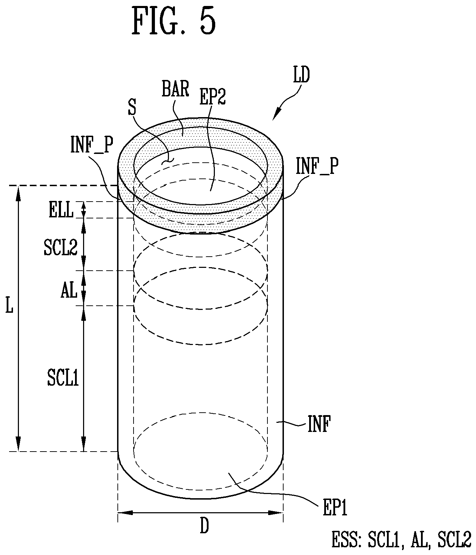

Next, a light emitting element LD in accordance with a second embodiment will be described with reference to FIGS. 4 and 5. Descriptions overlapping that of the embodiments described above will be simplified, or may not be repeated. The second embodiment will be described focused on differences from the previous embodiment.

FIGS. 4 and 5 are schematic views each illustrating the light emitting element LD in accordance with the second embodiment. FIG. 4 is a schematic sectional view illustrating the light emitting element LD in accordance with the second embodiment. FIG. 5 is a schematic perspective view illustrating the light emitting element LD in accordance with the second embodiment.

The light emitting element LD in accordance with the second embodiment may be different from the light emitting element LD in accordance with the first embodiment at least in that the light emitting element LD in accordance with the second embodiment may further include a barrier layer BAR. The light emitting element LD in accordance with the second embodiment may further include a barrier layer BAR disposed on the insulating protrusion INF_P.

The barrier layer BAR may be disposed adjacent to the second end EP2. The barrier layer BAR may be disposed adjacent to the space S defined by the insulating protrusion INF_P.

The barrier layer BAR may have a shape corresponding to the shape of the insulating protrusion INF_P, in a plan view of the light emitting element LD (e.g., in a view seen in a direction from the second end EP2 toward the first end EP1).

The barrier layer BAR may include conductive material. An electrode(s) through which an anode signal or a cathode signal can be applied to the light emitting element LD may be more precisely electrically connected to a related component, so that an electrical connection defect of the light emitting element LD can be prevented from occurring.

The barrier layer BAR may include material which is resistant to dry etching. For example, the barrier layer BAR may include one or more selected from the group consisting of titanium (Ti) and tantalum (Ta). The barrier layer BAR may be a barrier structure, which is disposed under an etching mask while a dry etching process for the growth base GS is performed during a process of manufacturing the light emitting element LD. Detailed description pertaining to the foregoing will be made below.

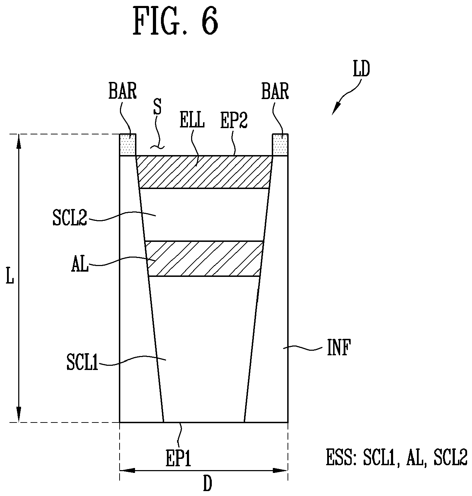

Next, a light emitting element LD in accordance with a third embodiment will be described with reference to FIG. 6. Descriptions overlapping that of the embodiments described above will be simplified, or may not be repeated. The third embodiment will be described focused on differences from the previous embodiments.

FIG. 6 is a schematic view illustrating the light emitting element LD in accordance with the third embodiment. FIG. 6 is a schematic sectional view illustrating the light emitting element LD in accordance with the third embodiment.

The light emitting element LD in accordance with the third embodiment may be different from the light emitting element LD in accordance with the second embodiment at least in that the cross-sectional area of the semiconductor stack structure ESS may vary in the longitudinal direction (L) of the light emitting element LD, and the thickness of the insulating layer INF may vary in the longitudinal direction (L) of the light emitting element LD. The thickness of the insulating layer INF of the light emitting element LD in accordance with the third embodiment may vary depending on the cross-sectional area of the semiconductor stack structure ESS at a corresponding position.

In the third embodiment, the cross-sectional area of the semiconductor stack structure ESS may be a cross-sectional area defined according to the direction in which the diameter D of the light emitting element LD is defined.

The cross-sectional area of the semiconductor stack structure ESS may be increased from the first end EP1 toward the second end EP2. For example, the cross-sectional area of the active layer AL may be greater than the cross-sectional area of the first semiconductor layer SCL1, and may be less than the cross-sectional area of the second semiconductor layer SCL2.

The thickness of the insulating layer INF may be reduced from the first end EP1 toward the second end EP2. For example, the thickness of the insulating layer INF at a position corresponding to the active layer AL may be less than the thickness of the insulating layer INF at a position corresponding to the first semiconductor layer SCL1, and may be greater than the thickness of the insulating layer INF at a position corresponding to the second semiconductor layer SCL2.

The cross-sectional area of the electrode layer ELL may be greater than the cross-sectional area of the semiconductor stack structure ESS. The thickness of the insulating layer INF at a position corresponding to the electrode layer ELL may be less than the thickness of the insulating layer INF at a position corresponding to the semiconductor stack structure ESS.

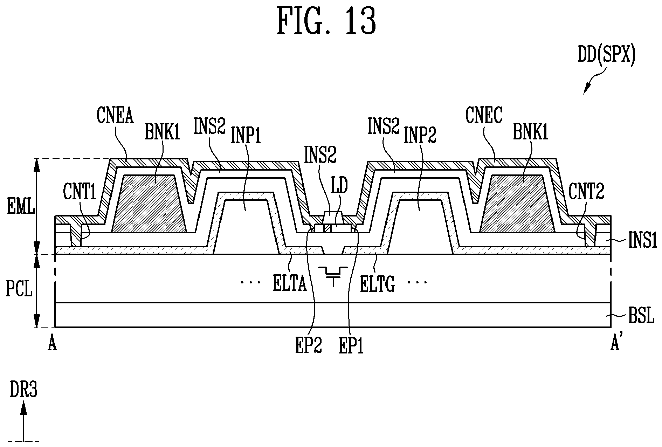

In an embodiment, the thickness of the insulating layer INF may be determined to be complementary to variation in cross-sectional area of the semiconductor stack structure ESS (i.e., the width/diameter of the semiconductor stack structure ESS) in the longitudinal direction (L). Hence, the overall cross-sectional area (or the overall diameter D) of the light emitting element LD may be substantially uniform in the longitudinal direction (L). The light emitting element LD may be efficiently aligned on the pixel circuit layer PCL (refer to FIG. 13) (e.g., on a backplane layer), and structural stability of the light emitting element LD may be secured.

In an embodiment, a surface area of an interface between the first semiconductor layer SCL1 and the active layer AL may be the same as a surface area of a surface of the active layer AL or a surface area of a surface of the first semiconductor layer SCL1. A surface area of an interface between the second semiconductor layer SCL2 and the active layer AL may be the same as a surface area of the other surface of the active layer AL or a surface area of a surface of the second semiconductor layer SCL2.

According to the third embodiment, the barrier layer BAR may be disposed on the insulating layer INF, and may be formed on a peripheral portion of the second end EP2 of the light emitting element LD. The barrier layer BAR may include material, which is resistant to dry etching, in a manner similar to that described above with reference to the second embodiment. In an embodiment, as the barrier layer BAR is disposed, electrical connection performance of the light emitting element LD may be enhanced.

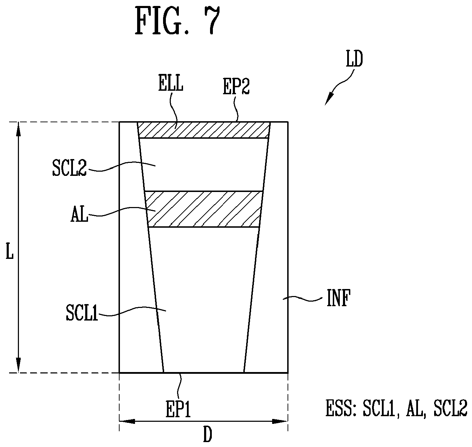

Next, a light emitting element LD in accordance with a fourth embodiment will be described with reference to FIG. 7. Descriptions overlapping that of the embodiments described above will be simplified, or may not be repeated. The fourth embodiment will be described focused on differences from the previous embodiments.

FIG. 7 is a schematic view illustrating the light emitting element LD in accordance with the fourth embodiment. FIG. 7 is a schematic sectional view illustrating the light emitting element LD in accordance with the fourth embodiment.

The light emitting element LD in accordance with the fourth embodiment may be different from the light emitting element LD in accordance with the third embodiment at least in that the barrier layer BAR is not formed. In the light emitting element LD in accordance with the fourth embodiment, the cross-sectional area of the semiconductor stack structure ESS and the thickness of the insulating layer INF may be formed complementary to each other, and a barrier layer BAR may not be disposed.

Depending on the embodiment, the barrier layer BAR may not be formed, and the length L of the light emitting element LD may be determined based on an area in which the insulating layer INF is formed. Respective portions of the insulating layer INF and the electrode layer ELL may form a uniform surface on the second end EP2 of the light emitting element LD.

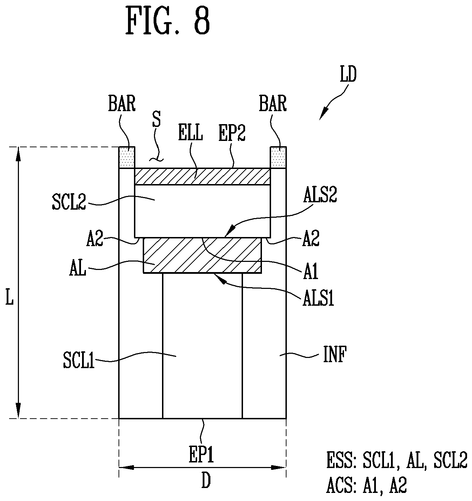

Next, a light emitting element LD in accordance with a fifth embodiment will be described with reference to FIG. 8. Descriptions overlapping that of the embodiments described above will be simplified, or may not be repeated. The fifth embodiment will be described focused on differences from the previous embodiments.

FIG. 8 is a schematic view illustrating the light emitting element LD in accordance with the fifth embodiment. FIG. 8 is a schematic sectional view illustrating the light emitting element LD in accordance with the fifth embodiment.

The light emitting element LD in accordance with the fifth embodiment may be different from the light emitting element LD in accordance with the third embodiment at least in that the cross-sectional area of the active layer AL may be greater than the cross-sectional area of the first semiconductor layer SCL1 and less than the cross-sectional area of the second semiconductor layer SCL2, and respective cross-sectional areas of each of the layers of the semiconductor stack structure ESS are substantially uniform.

In an embodiment, a first active surface ALS1 of the active layer AL may include a contact area which contacts the first semiconductor layer SCL1, and a non-contact area which does not contact the first semiconductor layer SCL1. For example, the cross-sectional area of the first semiconductor layer SCL1 may be less than the cross-sectional area of the active layer AL, so that a rate at which electrons are diffused through the first semiconductor layer SCL1 may be reduced.

In an embodiment, a second active surface ALS2 of the active layer AL may entirely contact the second semiconductor layer SCL2. For example, an active contact surface ACS of the second semiconductor layer SCL2 may include a first area A1 which contacts the second active surface ALS2 of the active layer AL, and a second area A2 which does not contact the second active surface ALS2 of the active layer AL. The second area A2 may enclose at least a portion of the first area A1.

In an embodiment, the semiconductor stack structure ESS may be designed such that the respective cross-sectional areas of each of the layers thereof are different from each other. Thereby, electrons may be prevented from overflowing through the first semiconductor layer SCL1. In an embodiment, an electron blocking layer may not be disposed between the active layer AL and the second semiconductor layer SCL2. Even in the case where a separate electron blocking layer is not disposed, the overflow of electrons can be prevented from occurring, and recombination efficiency of electrons-hole pairs may be enhanced. Experimentally, in the case where an electron blocking layer is disposed between the active layer AL and the second semiconductor layer SCL2, a strain may occur in the light emitting element LD because of lattice mismatch resulting from additional stacking. However, according to an embodiment, the overflow of electrons may be prevented so that the emission efficiency can be improved, and an additional layer is not essentially required. Consequently, processing steps may be facilitated. Furthermore, because no additional layer is disposed, a strain in the light emitting element LD may be reduced.

In an embodiment, the thickness of the insulating layer INF may vary depending on the kind of each layer of the semiconductor stack structure ESS. For example, the thickness of the insulating layer INF at a position corresponding to the active layer AL may be less than the thickness of the insulating layer INF at a position corresponding to the first semiconductor layer SCL1, and may be greater than the thickness of the insulating layer INF at a position corresponding to the second semiconductor layer SCL2. Here, the thickness of the insulating layer INF at a position corresponding to the active layer AL may be defined to be substantially uniform. The thickness of the insulating layer INF at a position corresponding to the first semiconductor layer SCL1 may be defined to be substantially uniform. The thickness of the insulating layer INF at a position corresponding to the second semiconductor layer SCL2 may be defined to be substantially uniform. Hence, the light emitting element LD may substantially have a uniform cross-sectional area (or a uniform diameter D) in the longitudinal direction (L).

According to the fifth embodiment, the barrier layer BAR may be disposed on the insulating layer INF, and may be formed on a peripheral portion of the second end EP2 of the light emitting element LD. The barrier layer BAR may include material, which is resistant to dry etching, in a manner similar to that described above with reference to the second embodiment. In an embodiment, as the barrier layer BAR is disposed, electrical connection performance of the light emitting element LD may be enhanced.

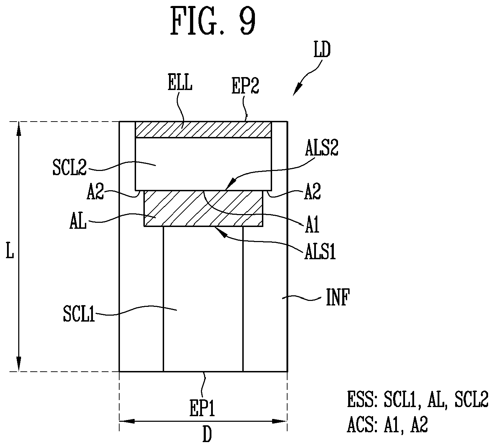

Next, a light emitting element LD in accordance with a sixth embodiment will be described with reference to FIG. 9. Descriptions overlapping that of the embodiments described above will be simplified, or may not be repeated. The sixth embodiment will be described focused on differences from the previous embodiments.

FIG. 9 is a schematic view illustrating the light emitting element LD in accordance with the sixth embodiment. FIG. 9 is a schematic sectional view illustrating the light emitting element LD in accordance with the sixth embodiment.

The light emitting element LD in accordance with the sixth embodiment may be different from the light emitting element LD in accordance with the fifth embodiment at least in that a barrier layer BAR is not formed. In the light emitting element LD in accordance with the sixth embodiment, the cross-sectional area of the active layer AL may be greater than the cross-sectional area of the first semiconductor layer SCL1 and less than the cross-sectional area of the second semiconductor layer SCL2, and respective cross-sectional areas of each of the layers of the semiconductor stack structure ESS are substantially uniform. A separate barrier layer BAR may not be disposed.

Depending on the embodiment, the barrier layer BAR may not be formed, and the length L of the light emitting element LD may be determined based on an area in which the insulating layer INF is formed. Respective portions of the insulating layer INF and the electrode layer ELL may form a uniform surface on the second end EP2 of the light emitting element LD.

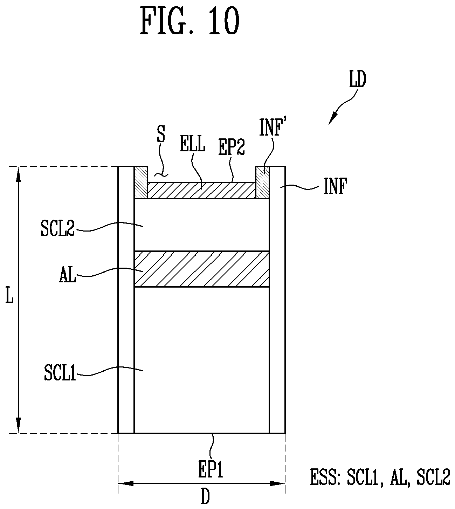

Next, a light emitting element LD in accordance with a seventh embodiment will be described with reference to FIG. 10. Descriptions overlapping that of the embodiments described above will be simplified, or may not be repeated. The seventh embodiment will be described focused on differences from the previous embodiment.

FIG. 10 is a schematic view illustrating the light emitting element LD in accordance with the seventh embodiment. FIG. 10 is a schematic sectional view illustrating the light emitting element LD in accordance with the seventh embodiment.

The light emitting element LD in accordance with the seventh embodiment may be different from the light emitting element LD in accordance with the first embodiment at least in that the light emitting element LD in accordance with the seventh embodiment may further include an inner insulating layer INF'. The light emitting element LD in accordance with the seventh embodiment may further include an inner insulating layer INF' formed adjacent to the electrode layer ELL.

In the seventh embodiment, the insulating layer INF may be referred to as a first insulating layer, and the inner insulating layer INF' may be referred to as a second insulating layer.

The inner insulating layer INF' may be disposed on an inner side surface of the insulating layer INF. At least a portion of the inner insulating layer INF' may be disposed between the electrode layer ELL and the insulating layer INF. The inner insulating layer INF' may enclose at least a portion of the electrode layer ELL, in a plan view of the light emitting element LD (e.g., in a view seen in a direction from the second end EP2 toward the first end EP1). At least a portion of the inner insulating layer INF' may be enclosed by the insulating layer INF, in a plan view of the light emitting element LD (e.g., in a view seen in a direction from the second end EP2 toward the first end EP1).

In the specification, the inner side surface may mean a portion of a side surface facing a central portion of an object. The central portion of the object may mean a central area of an upper surface or a lower surface of the object.

The inner insulating layer INF' and the insulating layer INF may have different internal structures. For example, the inner insulating layer INF' may include material having an amorphous structure. The insulating layer INF includes material having a crystalline structure. For example, the inner insulating layer INF' may include an inorganic material which does not have a crystalline structure, and the insulating layer INF may include an inorganic material having a crystalline structure. For example, the inner insulating layer INF' may include one or more materials selected from the group consisting of silicon oxide (SiOₓ), silicon nitride (SiNₓ), silicon oxynitride (SiOₓN_{y}), aluminium oxide (AlₓO_{y}), and titanium oxide (TiOₓ). However, the disclosure is not limited to the foregoing example.

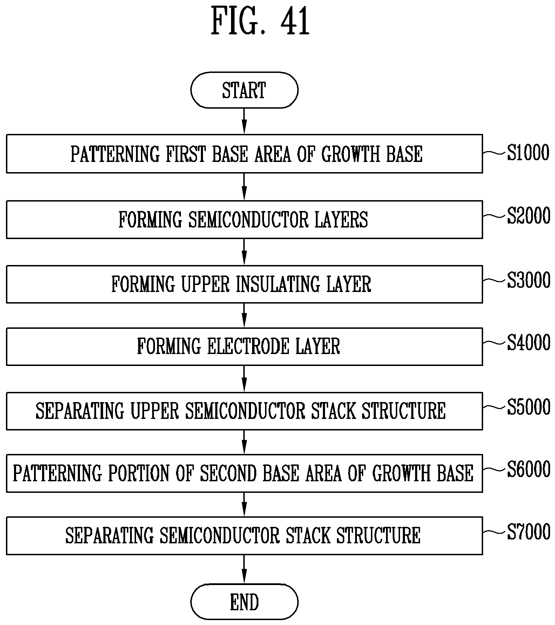

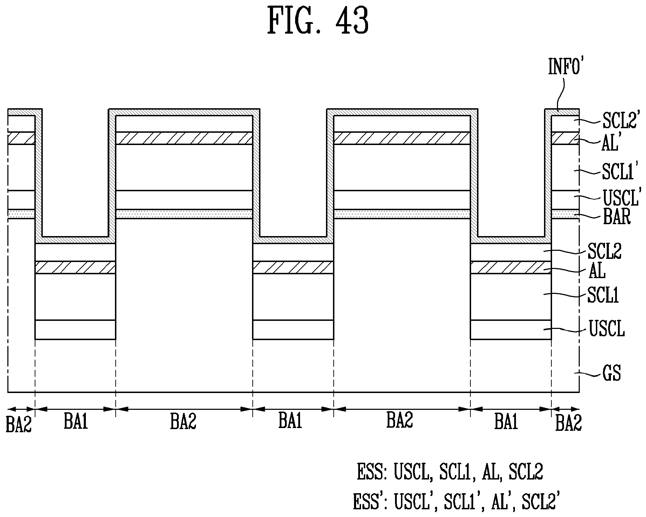

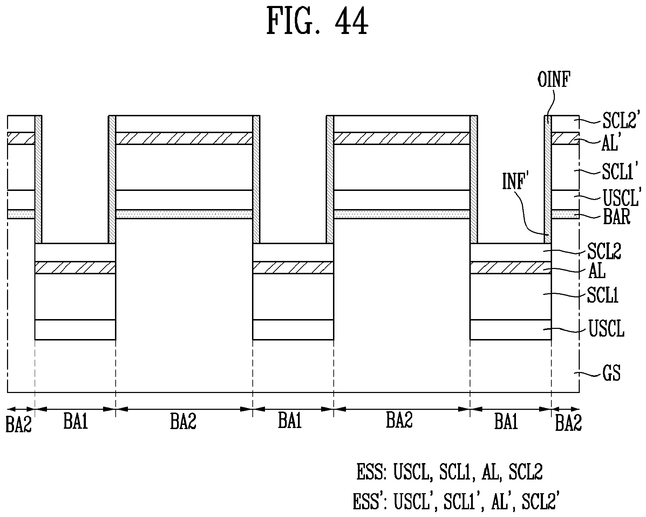

In an embodiment, the inner insulating layer INF' and the insulating layer INF may be manufactured through different processes. For example, the insulating layer INF may have a structure manufactured by patterning the growth base GS, and the inner insulating layer INF' may have a structure manufactured through a separate vapor deposition process (e.g., a chemical vapor deposition (CVD), or the like). In an embodiment, the number of light emitting elements LD which can be manufactured from the same number of growth bases GS may be increased, and the processing cost may be reduced. Detailed description of the foregoing will be made below with reference to FIGS. 41 to 49.

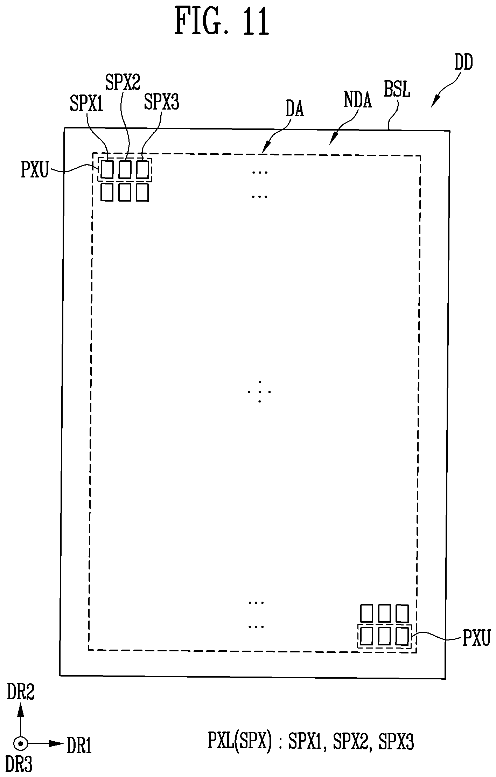

Next, a display device DD in accordance with an embodiment will be described with reference to FIGS. 11 to 16. Description overlapping that of the embodiments described above will be simplified, or may not be repeated.

FIG. 11 is a schematic plan view illustrating a display device DD in accordance with an embodiment.

The display device DD may be configured to emit light. The display device DD may include a light emitting element LD. In an embodiment, the display device DD may be provided in various shapes. For example, the display device DD may be applied to a smart phone, a notebook computer, a table personal computer (PC), a wearable device (e.g., a head-mounted device, a smart watch, and smart glasses, etc.), a television, or an in-vehicle infotainment system, and the like, and may be applied to various other devices.

Referring to FIG. 11, the display device DD may include a base layer BSL, and pixels PXL disposed on the base layer BSL. The display device DD may further include a driving circuit component (e.g., a scan driver and a data driver), lines, and pads which are provided to drive the pixels PXL.

The display device DD may include a display area DA and a non-display area NDA. The non-display area NDA may refer to an area other than the display area DA. The non-display area NDA may enclose at least a portion of the display area DA.

The base layer BSL may form a base of the display device DD. The base layer BSL may be a rigid or flexible substrate or film. For example, the base layer BSL may be a rigid substrate made of glass or reinforced glass, a flexible substrate (or a thin film) formed of plastic or metal, or at least one insulating layer. The material and/or properties of the base layer BSL are not particularly limited. In an embodiment, the base layer BSL may be substantially transparent. Here, the words "substantially transparent" may mean that light can pass through the base layer BSL with a transmittance of a certain value or more. In an embodiment, the base layer BSL may be translucent or opaque. Furthermore, the base layer BSL may include reflective material depending on the embodiment.

The display area DA may refer to an area in which the pixels PXL are disposed. The non-display area NDA may refer to an area in which the pixels PXL are not disposed. The driving circuit components, the lines, and the pads which are connected to the pixels PXL of the display area DA may be disposed in the non-display area NDA.

In an embodiment, pixels PXL (or sub-pixels SPX) may be arranged according to a stripe or PENTILE^{®} arrangement structure. However, the disclosure is not limited to the foregoing.

In an embodiment, each pixel PXL may include a light emitting element LD. The pixel PXL (or sub-pixels SPX) may include a first sub-pixel SPX1, a second sub-pixel SPX2, and a third sub-pixel SPX3. At least one first sub-pixel SPX1, at least one second sub-pixel SPX2, and at least one third sub-pixel SPX3 may form one pixel unit PXU which may emit various colors of light.

For example, each of the first sub-pixel SPX1, the second sub-pixel SPX2, and the third sub-pixel SPX3 may emit a color of light. For instance, the first sub-pixel SPX1 may be a red pixel configured to emit red (e.g., first color) light, the second sub-pixel SPX2 may be a green pixel configured to emit green (e.g., second color) light, and the third sub-pixel SPX3 may be a blue pixel configured to emit blue (e.g., third color) light. The color, type, and/or number of the first sub-pixel SPX1, the second sub-pixel SPX2, and the third sub-pixel SPX3 which form each pixel unit PXU is not limited to a specific example.

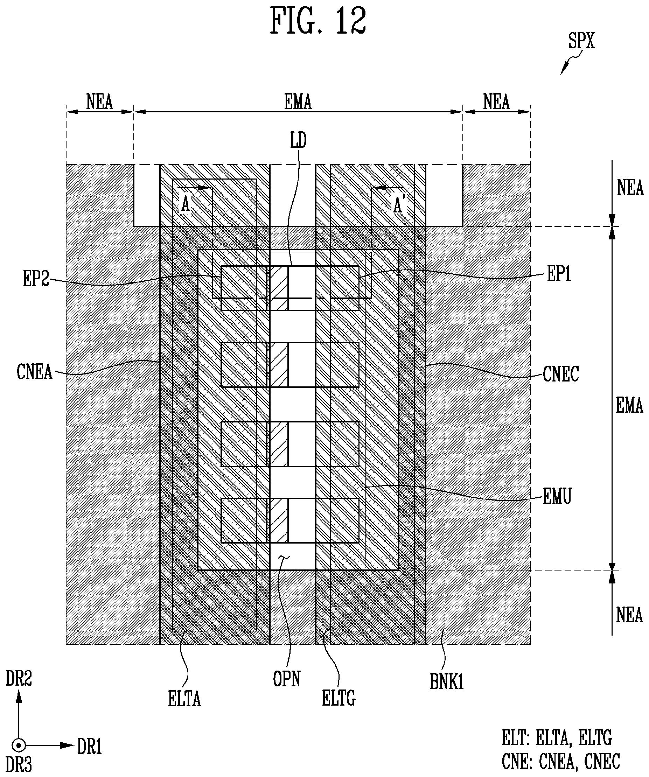

Schematic planar and cross-sectional structures of the display device DD in accordance with an embodiment will be described with reference to FIGS. 12 to 16. FIG. 12 is a schematic plan view illustrating a sub-pixel in accordance with an embodiment.

The sub-pixel SPX may include an emission area EMA and a non-emission area NEA. The sub-pixel SPX may include a first bank BNK1, an alignment electrode layer ELT, a light emitting element LD, and a connection electrode layer CNE.

In a plan view, the emission area EMA may overlap an opening OPN defined by the first bank BNK1. Light emitting elements LD may be disposed in the emission area EMA. The light emitting elements LD may not be disposed in the non-emission area NEA.

The first bank BNK1 may form (or provide) an opening OPN. For example, the first bank BNK1 may have a shape, protruding in a thickness direction of the base layer BSL (e.g., in a third direction DR3), and may enclose an area. In an embodiment, ink including light emitting elements LD may be supplied to the opening OPN defined by the first bank BNK1 so that the light emitting elements LD may be disposed in the opening OPN.

In an embodiment, the first bank BNK1 may include organic material such as acrylic resin, epoxy resin, phenolic resin, polyamide resin, polyimide resin, polyester resin, polyphenylene sulfide resin, and/or benzocyclobutene (BCB). However, the disclosure is not limited to the foregoing example.

The alignment electrode layer ELT may include electrodes for aligning the light emitting elements LD. In an embodiment, the alignment electrode layer ELT may include a first electrode ELTA and a second electrode ELTG. In an embodiment, the first electrode ELTA may be a first alignment electrode, and the second electrode ELTG may be a second alignment electrode.

The light emitting elements LD may be disposed (or aligned) on the alignment electrode layer ELT. In an embodiment, the light emitting elements LD may be aligned between the first electrode ELTA and the second electrode ELTG, in a plan view. The light emitting elements LD may form (or constitute) an emission unit EMU.

In an embodiment, the first electrode ELTA and the second electrode ELTG may be spaced apart from each other in the first direction DR1 in the emission area EMA.

In an embodiment, the first electrode ELTA that is the first alignment electrode may be an electrode through which an AC signal may be supplied to align the light emitting elements LD. The first electrode ELTA may be an electrode through which an anode signal may be supplied to allow the light emitting elements LD to emit light. The second electrode ELTG that is the second alignment electrode may be an electrode through which a ground signal may be supplied to align the light emitting elements LD. The second electrode ELTG may be an electrode through which a cathode signal can be supplied to allow the light emitting elements LD to emit light.

The first electrode ELTA (or the first alignment electrode) and the second electrode ELTG (or the second alignment electrode) may be respectively supplied (provided) with a first alignment signal and a second alignment signal at a processing step of aligning the light emitting elements LD. For example, ink comprising the light emitting elements LD may be supplied (or provided) to the opening OPN, the first alignment signal may be supplied to the first electrode ELTA, and the second alignment signal may be supplied to the second electrode ELTG. The first alignment signal and the second alignment signal may have different waveforms, different potentials, and/or different phases. For example, the first alignment signal may be an AC signal, and the second alignment signal may be a ground signal. However, the disclosure is not limited to the foregoing example. An electric field may be formed between (or over) the first electrode ELTA and the second electrode ELTG, so that the light emitting elements LD may be aligned between the first electrode ELTA and the second electrode ELTG based on the electric field. For example, the light emitting elements LD may be moved (or rotated) by force (e.g., dielectrophoresis (DEP) force} derived from the electric field and thus be aligned (or disposed) on the first alignment electrode and the second alignment electrode.

Each light emitting element LD may emit light based on a provided electrical signal. For example, the light emitting element LD may provide light based on a first electrical signal (for example, an anode signal) provided from an anode connection electrode CNEA and a second electrical signal (for example, a cathode signal) provided from a cathode connection electrode CNEC.

The second end EP2 of the light emitting element LD may be disposed adjacent to the first electrode ELTA. The first end EP1 of the light emitting element LD may be disposed adjacent to the second electrode ELTG.

The connection electrode layer CNE may be disposed on the first ends EP1 and the second ends EP2 of the light emitting elements LD. The anode connection electrode CNEA may be disposed on the second ends EP2 of the light emitting elements LD such that the anode connection electrode CNEA is electrically connected to the second ends EP2. The cathode connection electrode CNEC may be disposed on the first ends EP1 of the light emitting elements LD such that the cathode connection electrode CNEC is electrically connected to the first ends EP1.

In an embodiment, the connection electrode layer CNE may include the anode connection electrode CNEA and the cathode connection electrode CNEC.

FIG. 13 illustrates a light-emitting-element layer EML in which the light emitting elements LD are disposed and the pixel circuit layer PCL including a pixel circuit. FIG. 13 is a schematic sectional view taken along line A-A' of FIG. 12.

Referring to FIG. 13, the display device DD may include the pixel circuit layer PCL and the light-emitting-element layer EML.

The pixel circuit layer PCL may be a layer including a pixel circuit configured to drive the light emitting elements LD. The pixel circuit layer PCL may include a base layer BSL, metal layers provided to form pixel circuits, and insulating layers disposed between the metal layers. In an embodiment, the base layer BSL may form a base surface for supporting the display device DD.

In an embodiment, each of the pixel circuits may include a thin film transistor. The pixel circuits each may further include a storage capacitor. The pixel circuits may be electrically connected to the light emitting elements LD, and may provide electrical signals allowing the light emitting elements LD to emit light.

The light-emitting-element layer EML may be disposed on the pixel circuit layer PCL. The light-emitting-element layer EML may include first and second insulating patterns INP1 and INP2, an alignment electrode layer ELT, a first insulating layer INS1, a first bank BNK1, a light emitting element LD, a second insulating layer INS2, and a connection electrode layer CNE.

The first and second insulating patterns INP1 and INP2 may be disposed on a passivation layer. Each of the first and second insulating patterns INP1 and INP2 may have various shapes depending on the embodiment. In an embodiment, the first and second insulating patterns INP1 and INP2 may protrude in the thickness direction of the base layer BSL (e.g., in the third direction DR3).

The first and second insulating patterns INP1 and INP2 may form a step difference so that the light emitting elements LD can be readily aligned in the emission area EMA. In an embodiment, each of the first and second insulating patterns INP1 and INP2 may be a partition wall. In an embodiment, each of the first and second insulating patterns INP1 and INP2 may include at least one organic material and/or inorganic material. However, the disclosure is not limited to a particular example.

The alignment electrode layer ELT may be disposed on the passivation layer and/or the first and second insulating patterns INP1 and INP2. The first electrode ELTA may be supplied with a first alignment signal and/or first power through a first contact component. The second electrode ELTG may be supplied with a second alignment signal and/or second power through a second contact component.

The first insulating layer INS1 may be disposed on the alignment electrode layer ELT. For example, the first insulating layer INS1 may cover the first electrode ELTA and the second electrode ELTG.

The first bank BNK1 may be disposed on the first insulating layer INS1. The first bank BNK1 may form space capable of receiving ink including the light emitting elements LD therein, as described above.

The light emitting elements LD may be disposed on the first insulating layer INS1 in an area enclosed by the first bank BNK1. In an embodiment, each of the light emitting elements LD may emit light based on electrical signals (e.g., an anode signal and a cathode signal) provided from the anode connection electrode CNEA and the cathode connection electrode CNEC.

The second insulating layer INS2 may be disposed on the light emitting elements LD. The second insulating layer INS2 may cover the active layer AL of each light emitting element LD. The second insulating layer INS2 allows at least a portion of the light emitting element LD to be exposed. For example, the second insulating layer INS2 may not cover the first end EP1 and the second end EP2 of the light emitting element LD. Hence, the first end EP1 and the second end EP2 of the light emitting element LD may be exposed and respectively electrically connected to the anode connection electrode CNEA and the cathode connection electrode CNEC. In an embodiment, another portion of the second insulating layer INS2 may be disposed on the first bank BNK1 and the first insulating layer INS1.

In the case in which the second insulating layer INS2 is formed on the light emitting elements LD after the alignment of the light emitting elements LD have been completed, the light emitting elements LD may be prevented from being removed from the aligned positions.

The second insulating layer INS2 may have a single-layer or multilayer structure. The second insulating layer INS2 may include one or more selected from the group consisting of silicon oxide (SiOₓ), silicon nitride (SiNₓ), silicon oxynitride (SiOₓN_{y}), aluminium nitride (AlNₓ), aluminium oxide (AlₓO_{y}), zirconium oxide (ZrOₓ), hafnium oxide (HfOₓ), and titanium oxide (TiOₓ). However, the disclosure is not limited to the foregoing example.

The anode connection electrode CNEA and the cathode connection electrode CNEC may be disposed on the first insulating layer INS1 and the second insulating layer INS2. The anode connection electrode CNEA may be electrically connected to the second end EP2 of the light emitting element LD. The cathode connection electrode CNEC may be electrically connected to the first end EP1 of the light emitting element LD.

The anode connection electrode CNEA may be electrically connected to the first electrode ELTA through a first contactor CNT1 passing through the first insulating layer INS1 and the second insulating layer INS2. The cathode connection electrode CNEC may be electrically connected to the second electrode ELTG through a second contactor CNT2 passing through the first insulating layer INS1 and the second insulating layer INS2. In an embodiment, the anode connection electrode CNEA may be directly electrically connected to a line of the pixel circuit layer PCL through the first contactor CNT1. The cathode connection electrode CNEC may be directly electrically connected to a line of the pixel circuit layer PCL through the second contactor CNT2.

In an embodiment, the anode connection electrode CNEA and the cathode connection electrode CNEC may be patterned at the same time point through the same process. However, the disclosure is not limited to the foregoing example. After any one of the anode connection electrode CNEA and the cathode connection electrode CNEC is patterned, the other electrode may be patterned.

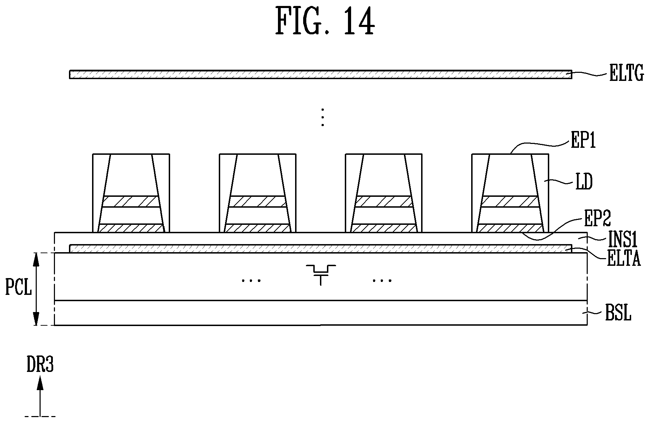

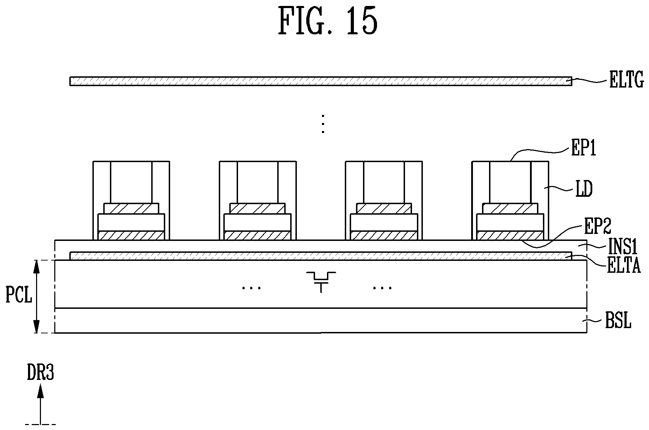

A structure in which the ends EP1 and EP2 of the light emitting elements LD in accordance with an embodiment are oriented in the vertical direction will be described with reference to FIGS. 14 and 15.

FIG. 14 is a schematic sectional view illustrating a display device in accordance with an embodiment. FIG. 14 illustrates an embodiment in which the light emitting elements LD in accordance with the third embodiment or the fourth embodiment are aligned on the pixel circuit layer PCL.

FIG. 15 is a schematic sectional view illustrating a display device in accordance with an embodiment. FIG. 15 illustrates an embodiment in which the light emitting elements LD in accordance with the fifth embodiment or the sixth embodiment are aligned on the pixel circuit layer PCL.

Depending on the embodiment, the light emitting elements LD in accordance with the third to sixth embodiments may be aligned such that the longitudinal direction (L) thereof is oriented in the vertical direction (e.g., the thickness direction of the base layer BSL or the third direction DR3). For example, FIGS. 14 and 15 illustrate that the light emitting elements LD in accordance with an embodiment may be aligned in the vertical direction.

Referring to FIGS. 14 and 15, the light emitting elements LD may be aligned such that the longitudinal direction (L) thereof is parallel to the thickness direction (e.g., the third direction DR3) of the base layer BSL.

For example, the first end EP1 and the second end EP2 of each of the light emitting elements LD may be spaced apart from each other in the thickness direction of the base layer BSL. In an embodiment, the first electrode ELTA and the second electrode ELTG may be spaced apart from each other in the third direction DR3 with the light emitting elements LD interposed therebetween. Hence, the light emitting elements LD may be aligned based on an electric field defined between the first electrode ELTA and the second electrode ELTG that are spaced apart from each other in the vertical direction.

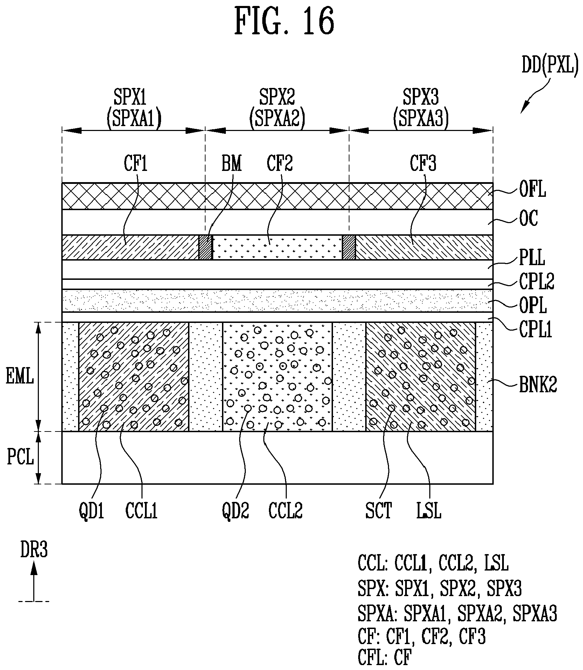

FIG. 16 is a schematic sectional view illustrating a pixel in accordance with an embodiment. FIG. 16 schematically illustrates a cross-sectional structure of sub-pixels SPX, focused on components disposed on the light-emitting-element layer EML.

Referring to FIG. 16, sub-pixel areas SPXA corresponding to the respective sub-pixels SPX may be formed in the display area DA. The sub-pixel areas SPXA may include a first sub-pixel area SPXA1 corresponding to a first sub-pixel SPX1, a second sub-pixel area SPXA2 corresponding to a second sub-pixel SPX2, and a third sub-pixel area SPXA3 corresponding to a third sub-pixel SPX3. The first sub-pixel area SPXA1, the second sub-pixel area SPXA2, and the third sub-pixel area SPXA3 may be arranged in the first direction DR1.

A second bank BNK2 may be disposed between the first to third sub-pixel areas SPXA1, SPXA2, and SPXA3 or on boundaries therebetween, and define spaces (or areas) which respectively overlap the first to third sub-pixel areas SPXA1, SPXA2, and SPXA3. The space defined by the second bank BNK2 may be an area in which a color conversion layer CCL can be provided.

The second bank BNK2 may be disposed to enclose an area in the light-emitting-element layer EML. The second bank BNK2 may protrude in the thickness direction of the base layer BSL (e.g., in the third direction DR3), so that the second bank BNK2 can define an area. Space to which the color conversion layer CCL is to be provided may be formed in an area defined by the second bank BNK2.

The second bank BNK2 may include organic material such as acrylic resin, epoxy resin, phenol resin, polyamide resin, polyimide resin, polyester resin, polyphenylene sulfide resin, and/or benzocyclobutene. However, the disclosure is not limited to the foregoing.

The color conversion layer CCL may be disposed on the light emitting elements LD in the space enclosed by the second bank BNK2. The color conversion layer CCL may include a first color conversion layer CCL1 disposed in the first sub-pixel SPX1, a second color conversion layer CCL2 disposed in the second sub-pixel SPX2, and a light scattering layer LSL disposed in the third sub-pixel SPX3.

The color conversion layer CCL may be disposed on the light emitting element LD. The color conversion layer CCL may be formed to change the wavelength of light. In an embodiment, the first to third sub-pixels SPX1, SPX2, and SPX3 may include light emitting elements LD configured to emit the same color of light. For example, the first to third sub-pixels SPX1, SPX2, and SPX3 may include light emitting elements LD configured to emit the third color of light (or blue light). Because the color conversion layer CCL including color conversion particles is disposed in each of the first to third sub-pixels SPX1, SPX2, and SPX3, a full-color image may be displayed.

The first color conversion layer CCL1 may include first color conversion particles for converting the third color of light emitted from the light emitting element LD to the first color of light. For example, the first color conversion layer CCL1 may include multiple first quantum dots QD1 which are dispersed in a matrix material such as base resin.

In an embodiment, in the case where the light emitting element LD is a blue light emitting element configured to emit blue light and the first sub-pixel SPX1 is a red pixel, the first color conversion layer CCL1 may include the first quantum dots QD1 which may convert blue light emitted from the blue light emitting element to red light. The first quantum dots QD1 may absorb blue light, shift the wavelength thereof according to an energy transition, and thus emit red light. In the case that the first sub-pixel SPX1 is one of pixels of other colors, the first color conversion layer CCL1 may include the first quantum dots QD1 corresponding to the color of the first sub-pixel SPX1.

The second color conversion layer CCL2 may include second color conversion particles for converting the third color of light emitted from the light emitting element LD to the second color of light. For example, the second color conversion layer CCL2 may include multiple second quantum dots QD2 which are dispersed in a matrix material such as base resin.

In an embodiment, in the case where the light emitting element LD is a blue light emitting element configured to emit blue light and the second sub-pixel SPX2 is a green pixel, the second color conversion layer CCL2 may include the second quantum dots QD2 which may convert blue light emitted from the blue light emitting element to green light. The second quantum dots QD2 may absorb blue light, shift the wavelength thereof according to an energy transition, and thus emit green light. In the case in which the second sub-pixel SPX2 is one of pixels of other colors, the second color conversion layer CCL2 may include the second quantum dots QD2 corresponding to the color of the second sub-pixel SPX2.

In an embodiment, as blue light having a relatively short wavelength in a visible ray area is incident on each of the first quantum dots QD1 and the second quantum dots QD2, absorption coefficients of the first quantum dot QD1 and the second quantum dot QD2 may be increased. Therefore, eventually, the efficiency of light emitted from the first sub-pixel SPX1 and the second sub-pixel SPX2 may be enhanced, and satisfactory color reproducibility may be secured. Furthermore, because the emission unit EMU for the first to third sub-pixels SPX1, SPX2, and SPX3 is formed of light emitting elements LD (e.g., blue light emitting elements) configured to emit the same color of light, the efficiency of manufacturing the display device DD may be enhanced.

The light scattering layer LSL may be provided to efficiently use the third color of light (or blue light) emitted from the light emitting element LD. For example, in the case where the light emitting element LD is a blue light emitting element configured to emit blue light and the third sub-pixel SPX3 is a blue pixel, the light scattering layer LSL may include at least one type of light scatterer SCT to efficiently use light emitted from the light emitting element LD. For example, the light scatterer SCT may include one or more selected from the group consisting of silica (SiOₓ) (e.g., silica beads, hollow silica particles, or the like), titanium oxide (TiOₓ), zirconium oxide (ZrOₓ), aluminium oxide (AlₓO_{y}), indium oxide (InₓO_{y}), zinc oxide (ZnOₓ), tin oxide (SnOₓ), and antimony oxide (SbₓO_{y}). However, the disclosure is not limited thereto.

The light scatterers SCT may not only be provided in the third sub-pixel SPX3, but may also be selectively comprised in the first color conversion layer CCL1 or the second color conversion layer CCL2. In an embodiment, the light scatterer SCT may be omitted, and the light scattering layer LSL including a transparent polymer may be provided.

A first capping layer CPL1 may be disposed on the color conversion layer CCL. The first capping layer CPL1 may be provided over the first to third sub-pixels SPX1, SPX2, and SPX3. The first capping layer CPL1 may cover the color conversion layer CCL. The first capping layer CPL1 may prevent the color conversion layer CCL from being damaged or contaminated by permeation of external impurities such as water or air.

The first capping layer CPL1 may be an inorganic layer, and be formed of one or more selected from the group consisting of silicon nitride (SiNₓ), aluminium nitride (AlNₓ), titanium nitride (TiNₓ), silicon oxide (SiOₓ), aluminium oxide (AlₓO_{y}), titanium oxide (TiOₓ), silicon oxycarbide (SiOₓC_{y}), and silicon oxynitride (SiOₓN_{y}).

An optical layer OPL may be disposed on the first capping layer CPL1. The optical layer OPL may function to recycle light provided from the color conversion layer CCL by total reflection and thus enhance light extraction efficiency. Hence, the optical layer OPL may have a relatively low refractive index compared to that of the color conversion layer CCL. For example, the refractive index of the color conversion layer CCL may range from approximately 1.6 to approximately 2.0, and the refractive index of the optical layer OPL may range from approximately 1.1 to approximately 1.3.

A second capping layer CPL2 may be disposed on the optical layer OPL. The second capping layer CPL2 may be provided over the first to third sub-pixels SPX1, SPX2, and SPX3. The second capping layer CPL2 may cover the optical layer OPL. The second capping layer CPL2 may prevent the optical layer OPL from being damaged or contaminated by permeation of external impurities such as water or air.

The second capping layer CPL2 may be an inorganic layer, and be formed of one or more selected from the group consisting of silicon nitride (SiNₓ), aluminium nitride (AlNₓ), titanium nitride (TiNₓ), silicon oxide (SiOₓ), aluminium oxide (AlₓO_{y}), titanium oxide (TiOₓ), silicon oxycarbide (SiOₓC_{y}), and silicon oxynitride (SiOₓN_{y}).

A planarization layer PLL may be disposed on the second capping layer CPL2. The planarization layer PLL may be provided over the first to third sub-pixels SPX1, SPX2, and SPX3.

The planarization layer PLL may include organic material such as acrylic resin, epoxy resin, phenol resin, polyamide resin, polyimide resin, polyester resin, polyphenylene sulfide resin, or benzocyclobutene. However, the disclosure is not limited thereto. The planarization layer PLL may include various types of inorganic materials including silicon oxide (SiOₓ), silicon nitride (SiNₓ), silicon oxynitride (SiOₓN_{y}), aluminium nitride (AlNₓ), aluminium oxide (AlₓO_{y}), zirconium oxide (ZrOₓ), hafnium oxide (HfOₓ), and titanium oxide (TiOₓ).

The color filter layer CFL may be disposed on the planarization layer PLL. The color filter layer CFL may include color filters CF1, CF2, and CF3 corresponding to the colors of the respective pixels PXL. Since the color filters CF1, CF2, and CF3 corresponding to the respective colors of the first to third sub-pixels SPX1, SPX2, and SPX3 are disposed, the display device DD may display a full-color image.

The color filter layer CFL may include a first color filter CF1 which is disposed in the first sub-pixel SPX1 and configured to allow light emitted from the first sub-pixel SPX1 to selectively pass therethrough, a second color filter CF2 which is disposed in the second sub-pixel SPX2 and configured to allow light emitted from the second sub-pixel SPX2 to selectively pass therethrough, and a third color filter CF3 which is disposed in the third sub-pixel SPX3 and configured to allow light emitted from the third sub-pixel SPX3 to selectively pass therethrough.

In an embodiment, the first color filter CF1, the second color filter CF2, and the third color filter CF3 may be respectively a red color filter, a green color filter, and a blue color filter, but the disclosure is not limited thereto. Hereinafter, the term "color filter CF" or "color filters CF" will be used to designate any color filter among the first color filter CF1, the second color filter CF2, and the third color filter CF3, or collectively designate two or more kinds of color filters.

The first color filter CF1 may overlap the first color conversion layer CCL1 in the thickness direction of the base layer BSL (e.g., the third direction DR3). The first color filter CF1 may include color filter material for allowing the first color of light (or red light) to selectively pass therethrough. For example, in the case where the first sub-pixel SPX1 is a red pixel, the first color filter CF1 may include red color filter material.

The second color filter CF2 may overlap the second color conversion layer CCL2 in the thickness direction of the base layer BSL (e.g., the third direction DR3). The second color filter CF2 may include color filter material for allowing the second color of light (or green light) to selectively pass therethrough. For example, in the case where the second sub-pixel SPX2 is a green pixel, the second color filter CF2 may include green color filter material.

The third color filter CF3 may overlap the light scattering layer LSL in the thickness direction of the base layer BSL (e.g., the third direction DR3). The third color filter CF3 may include color filter material for allowing the third color of light (or blue light) to selectively pass therethrough. For example, in the case where the third sub-pixel SPX3 is a blue pixel, the third color filter CF3 may include blue color filter material.

In an embodiment, a light blocking layer BM may be further disposed between the first to third color filters CF1, CF2, and CF3. In the case in which the light blocking layer BM is formed between the first to third color filters CF1, CF2, and CF3, a color mixing defect which is visible from a front surface or side surface of the display device DD may be prevented from occurring. The material of the light blocking layer BM is not particularly limited, and various light blocking materials may be used to form the light blocking layer BM. For example, the light blocking layer BM may include a black matrix, or be embodied by stacking the first to third color filters CF1, CF2, and CF3 on each other.

An overcoat layer OC may be disposed on the color filter layer CFL. The overcoat layer OC may be provided over the first to third sub-pixels SPX1, SPX2, and SPX3. The overcoat layer OC may cover a lower component including the color filter layer CFL. The overcoat layer OC may prevent water or air from permeating the lower component. Furthermore, the overcoat layer OC may protect the lower component from foreign material such as dust.

The overcoat layer OC may include organic material such as acrylic resin, epoxy resin, phenol resin, polyamide resin, polyimide resin, polyester resin, polyphenylene sulfide resin, and/or benzocyclobutene. However, the disclosure is not limited thereto. The planarization layer PLL may include various types of inorganic materials including silicon oxide (SiOₓ), silicon nitride (SiNₓ), silicon oxynitride (SiOₓN_{y}), aluminium nitride (AlNₓ), aluminium oxide (AlₓO_{y}), zirconium oxide (ZrOₓ), hafnium oxide (HfOₓ), and/or titanium oxide (TiOₓ).

The outer film layer OFL may be disposed on the overcoat layer OC. The outer film layer OFL may be disposed on an outer portion of the display device DD based on the thickness direction (e.g., the third direction DR3) of the base layer BSL, thus reducing external influences. The outer film layer OFL may be provided over the first to third sub-pixels SPX1, SPX2, and SPX3. In an embodiment, the outer film layer OFL may include at least one selected from the group consisting of a polyethyleneterephthalate (PET) film, a low reflection film, a polarizing film, and a transmittance controllable film. However, the disclosure is not limited to the foregoing. In an embodiment, the pixel PXL may include an upper substrate other than including the outer film layer OFL.

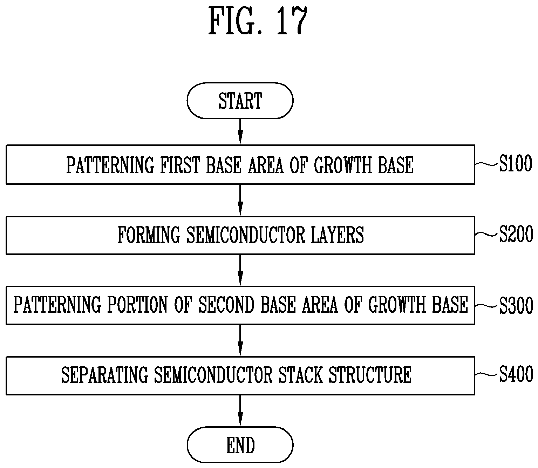

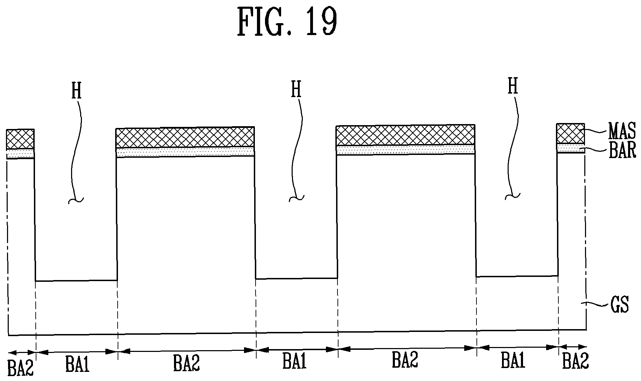

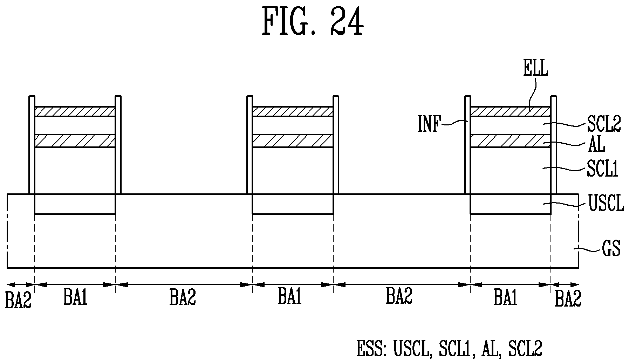

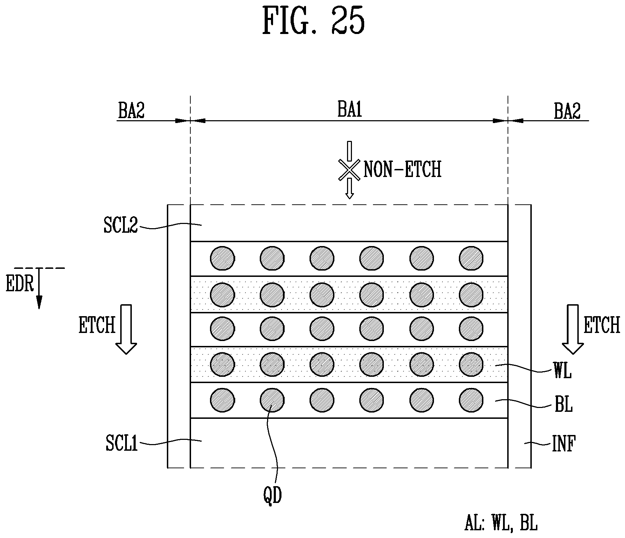

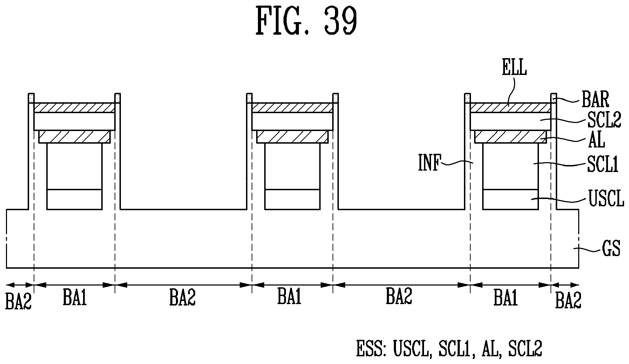

Hereinafter, a method of manufacturing a light emitting element LD in accordance with an embodiment will be described with reference to FIGS. 17 to 48. Description overlapping that of the embodiments described above will be simplified, or may not be repeated.

First, a method of manufacturing the light emitting elements LD in accordance with the first to sixth embodiments will be described with reference to FIGS. 17 to 40.

FIGS. 17 to 40 are views illustrating the method of manufacturing the light emitting element in accordance with the first to sixth embodiments. FIG. 17 is a flowchart illustrating the method of manufacturing the light emitting elements in accordance with the first to sixth embodiments.

The method of manufacturing the light emitting element LD in accordance with the first to sixth embodiments may include step S100 of patterning a first base area of the growth base, step S200 of forming semiconductor layers, step S300 of patterning a portion of a second base area of the growth base, and step S400 of separating the semiconductor stack structure.

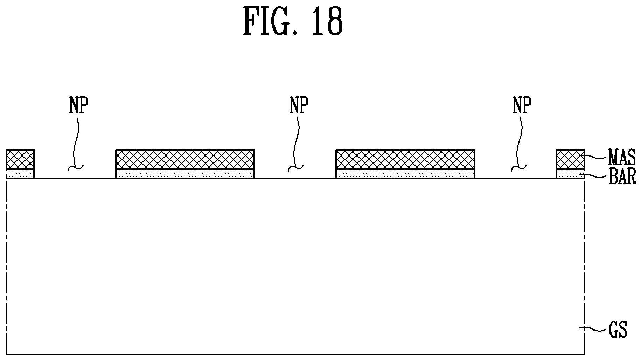

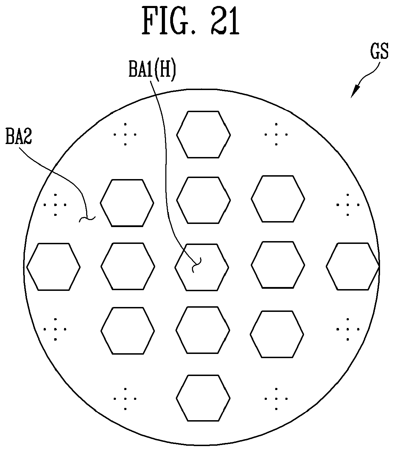

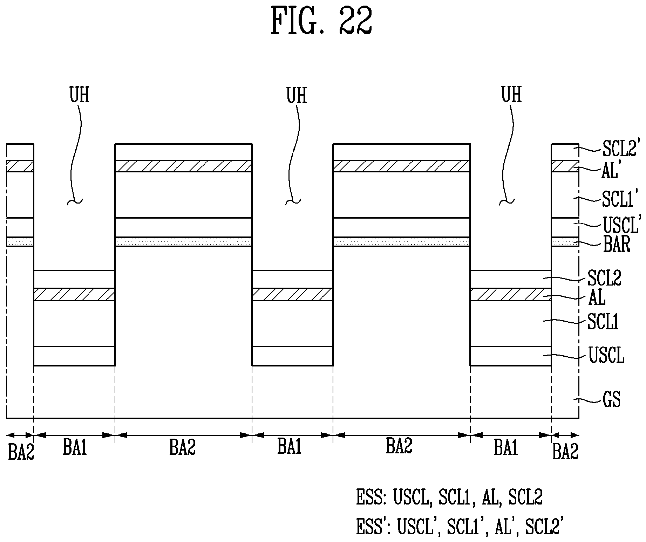

Hereinafter, a method of manufacturing the light emitting element LD in accordance with the first embodiment will be described with reference to FIGS. 17 to 26. FIGS. 18 to 26 are schematic views illustrating, by process steps, the method of manufacturing the light emitting element LD in accordance with the first embodiment. FIGS. 18, 19, and 22 to 26 are schematic sectional views illustrating, by process steps, the method of manufacturing the light emitting element LD in accordance with the first embodiment. FIGS. 21 and 22 are schematic plan views illustrating, by process steps, the method of manufacturing the light emitting element LD in accordance with the first embodiment.

Referring to FIGS. 17 to 21, at step S100 of patterning the first base area of the growth base, at least a portion of the growth base GS may be removed.

In the present phase, the growth base GS comprising a first base area BA1 and a second base area BA2 may be provided, and at least a portion of the growth base GS may be etched. The first base area BA1 may correspond to an area in which a portion of the growth base GS is to be etched. The second base area BA2 may include an area other than the first base area BA1.

In an embodiment, to pattern the growth base GS, a dry etching process may be performed. For example, the barrier layer BAR and a mask MAS may be patterned on the growth base GS. In an embodiment, the barrier layer BAR and the mask MAS may overlap each other in a plan view. The barrier layer BAR and the mask MAS may not be disposed in a partial area of the growth base GS, so that a non-disposition area NP may be formed. The barrier layer BAR and the mask MAS may allow the growth base GS in the non-disposition area NP to be exposed. The non-disposition area NP may overlap the first base area BA1, in a plan view.

In an embodiment, the barrier layer BAR may be disposed between the mask MAS and the growth base GS. In an embodiment, the barrier layer BAR may be a protective structure for covering the growth base GS, and may be a sacrificial structure to be removed as a subsequent process is performed. For example, the barrier layer BAR may include indium tin oxide (ITO), as a sacrificial structure. However, the disclosure is not limited to the foregoing.

The growth base GS may be a base plate provided to grow one material. For example, the growth base GS may be a wafer for epitaxial growth of a target material.

The growth base GS may include the same material as the insulating layer INF of the light emitting element LD to be manufactured. For example, as described above, in the case where the growth base GS includes aluminium oxide (AlₓO_{y}) as a sapphire substrate, the insulating layer INF may include aluminium oxide (AlₓO_{y}). In other embodiments, in the case where the growth base GS is formed of a silicon substrate (e.g., including silicon (Si) or silicon carbide (SiC)), the insulating layer INF may include silicon-based material.

In the present phase, the first base area BA1 of the growth base GS may be etched, and the second base area BA2 of the growth base GS may not be etched. As the first base area BA1 of the growth base GS is etched, portions of the growth base GS may be recessed inward so that holes H may be formed in the growth base GS.

For example, the area (e.g., the non-disposition area NP) in which the barrier layer BAR and the mask MAS are not disposed may overlap (or correspond to) the first base area BA1. In an embodiment, the area in which the barrier layer BAR and the mask MAS are disposed may overlap (or correspond to) the second base area BA2.

In the present phase, the shape of the formed holes H may correspond to that of the semiconductor stack structure ESS of the light emitting element LD to be manufactured. For example, in the present phase, each of the formed holes H may have a pillar shape extending in a direction. The semiconductor stack structure ESS of the manufactured light emitting element LD may have a pillar shape. In an embodiment, the holes H may have the same cross-sectional area (i.e., the same width/diameter) along the longitudinal direction (e.g., the thickness direction of the growth base GS).

In the present phase, the size of the formed holes H may correspond to that of the semiconductor stack structure ESS of the light emitting element LD. For example, the length of the holes H formed in the present phase may correspond to that of the semiconductor stack structure ESS of the manufactured light emitting element LD. In the present phase, the diameter of the formed holes H may correspond to that of the semiconductor stack structure ESS of the manufactured light emitting element LD.

In an embodiment, each of the holes H may be referred to as a well.

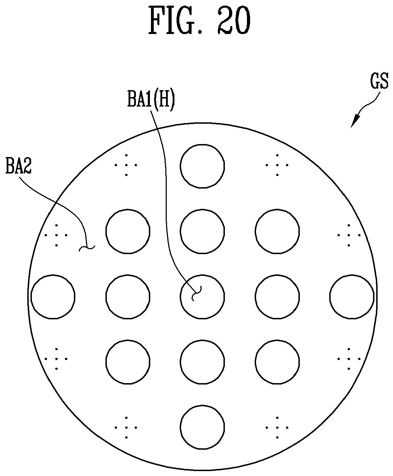

In the present phase, the shape of the non-disposition area NP may be determined depending on the shape of the cross-section of the light emitting element LD to be manufactured. For example, the growth base GS may be etched in the first base area BA1 corresponding to the non-disposition area NP. In an embodiment, the shape of the first base area BA1 (or the holes H) may be circular (refer to FIG. 20), in a plan view. In an embodiment, the shape of the first base area BA1 may be hexagonal (refer to FIG. 21), in a plan view. However, the disclosure is not limited thereto, and the first base area BA1 (or the holes H) may have various shapes including a polygonal shape, and the like.

Referring to FIGS. 17 and 22, at step S200 of forming semiconductor layers, the semiconductor layers are grown (or formed). In an embodiment, the step of removing the mask MAS may be performed, and the semiconductor layers may be successively formed so that a semiconductor stack structure ESS and an upper semiconductor stack structure ESS' may be formed. The semiconductor layers may be formed in various schemes such as an epitaxial growth method.

In the present phase, an undoped semiconductor layer USCL, USCL' a first semiconductor layer SCL1, SCL1', an active layer AL, AL', and a second semiconductor layer SCL2, SCL2' may be successively formed. Hence, the semiconductor stack structure ESS may be provided at a position overlapping (e.g., corresponding to) the first base area BA1. The upper semiconductor stack structure ESS' may be provided at a position overlapping (e.g., corresponding to) the second base area BA2.

As a subsequent process is performed, the semiconductor stack structure ESS that is individually patterned may be manufactured without performing a process of directly etching the semiconductor stack structured ESS to form the light emitting element LD.

Experimentally, in the case where the semiconductor stack structure ESS is individually patterned by performing the etching process for the semiconductor stack structure ESS to form the light emitting element LD, an outer surface of the semiconductor stack structure may be damaged, whereby there is a risk of reduction in emission efficiency (e.g., an increase in a non-emission recombination phenomenon).

In an embodiment, the outer surface of the semiconductor stack structure ESS may refer to an area including at least an exposed portion of the semiconductor stack structure ESS. The outer surface of the semiconductor stack structure ESS may be an exposed side surface of the semiconductor stack structure ESS, or may be an exposed upper surface of the semiconductor stack structure ESS. For example, the outer surface of the semiconductor stack structure ESS may include peripheral areas that define the shape of the semiconductor stack structure ESS.

However, in an embodiment, the semiconductor stack structure ESS may be individually patterned without performing an etching process to be applied to the semiconductor stack structure ESS, so that a risk of a reduction in emission efficiency of the light emitting element LD may be substantially reduced. For example, unnecessary leakage current in the light emitting element LD may be reduced, and occurrence of non-emission recombination or the like in the light emitting element LD may be reduced. Consequently, the light emitting element LD may be provided as a highly reliable diode.

In an embodiment, as a subsequent process is performed, the step of contacting the semiconductor stack structure ESS and a portion of the growth base GS that can form the insulating layer INF may be performed through the same process as the step of growing the semiconductor stack structure ESS. The outer surface of the semiconductor stack structure ESS may be passivated without performing a separate vapor deposition process of forming the insulating layer INF. For example, at the present phase, the insulating layer INF may cover the semiconductor stack structure ESS. In the present phase, the insulating layer INF may form a capping structure for protecting the semiconductor stack structure ESS.

In an embodiment, the upper semiconductor stack structure ESS' may be formed to protrude in a direction at a position overlapping the second base area BA2, and may be patterned to enclose an area. For example, the upper semiconductor stack structure ESS' may enclose upper holes UH. The upper holes UH may overlap the first base area BA1 and the semiconductor stack structure ESS, in a plan view.

In an embodiment, well layers WL and barrier layers BL which are provided to form the active layers AL and AL' may be alternately formed (or deposited). Hence, the active layers AL and AL' may be manufactured to have a quantum well structure. In an embodiment, the well layer WL and the barrier layer BL may be manufactured to include quantum particles QD by controlling growth conditions of the active layer AL. The quantum particles QD may be formed by various schemes including a molecular beam epitaxy (MBE) scheme and the like. The size of the quantum particle QD may be adjusted by controlling the growth conditions.

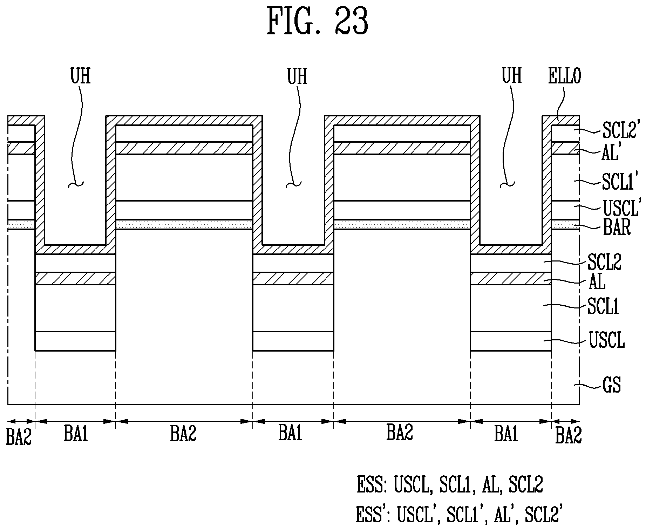

Referring to FIG. 23, after the semiconductor stack structure ESS and the upper semiconductor stack structure ESS' are formed, the step of forming (or depositing) a base electrode layer ELL0 may be further performed.

For example, the base electrode layer ELL0 may be formed in the first base area BA1 and the second base area BA2. In an embodiment, the base electrode layer ELL0 may include indium tin oxide (ITO). The base electrode layer ELL0 may be formed by various schemes including a sputtering process and the like, and the disclosure is not limited to a particular example.

Referring to FIGS. 17, 24, and 25, at step S300 of patterning a portion of the second base area of the growth base, at least a portion of the growth base GS may be removed, and the upper semiconductor stack structure ESS' may be removed.

In the present phase, a dry etching process of removing the upper semiconductor stack structure ESS' and at least a partial area of the growth base GS that overlaps the second base area BA2 may be performed. The dry etching process may be performed for at least a portion of the second base area BA2, and may not be performed for the first base area BA1.

For example, the dry etching process that is performed in the present phase may not be performed for the first base area BA1, so that the semiconductor stack structure ESS may not be etched. The dry etching process that is performed in the present phase may be performed for the second base area BA2, and may not be performed for at least a partial area of the second base area BA2.

In the present phase, at least a portion of the growth base GS that is directly adjacent to the semiconductor stack structure ESS may not be removed by an etching process. In the present phase, a portion of the growth base GS that is adjacent to the semiconductor stack structure ESS and is not removed by the etching process may be provided as an insulating layer INF for covering the semiconductor stack structure ESS.

The insulating layer INF for covering the semiconductor stack structure ESS may be manufactured without performing a deposition process for forming the insulating layer INF.

In an embodiment, a portion of the growth base GS may form the insulating layer INF of the light emitting element LD. In an embodiment, the growth base GS and the insulating layer INF may include the same material. For example, the growth base GS may include material having a crystalline structure. Likewise, the insulating layer INF may also include material having a crystalline structure.

In the present phase, as a partial area of the second base area BA2 remains, the insulating layer INF having the insulating protrusion INF_P (see FIG. 1) may be formed. The insulating layer INF having the insulating protrusion INF_P may cover the entirety of the side surface of the semiconductor stack structure ESS.

In the present phase, the etching process that is applied to the second base area BA2 may be performed in an etching direction EDR from an upper side toward a lower side. In an embodiment, the etching process (e.g., an etching range) that is applied to the second base area BA2 may not overlap the first base area BA1 in the etching direction EDR. The etching process (e.g., an etching range) that is applied to the second base area BA2 may overlap the second base area BA2 in the etching direction EDR, and may not overlap a portion of the second base area BA2, whereby the insulating layer INF may be manufactured. Because the etching process is not applied to the first base area BA1, the etching process may not be applied to the quantum particles QD formed in the active layer AL.

Experimentally, in the case where an area to which the etching process is applied overlaps the quantum particles QD in the etching direction EDR, the quantum particles QD may be damaged, so that an area where the quantum particles QD are disposed may be provided as a defective area of the active layer AL. The generated defect may occur a risk of a reduction in emission efficiency of the light emitting element LD. However, in an embodiment, the risk of application of the etching process to the quantum particles QD may be substantially removed, so that the light emitting element LD can be prevented from including defects, and the emission efficiency of the light emitting element LD may be enhanced.

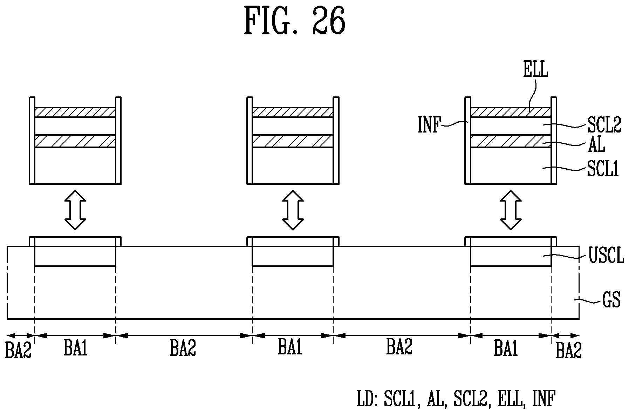

Referring to FIG. 17 and 26, at step S400 of separating the semiconductor stack structure, a portion of each of the first semiconductor layer SCL1 and the insulating layer INF may be cut, so that individually separated light emitting elements LD may be provided.

In the present phase, a laser-lift-off process or the like may be performed to separate the light emitting elements LD. However, the disclosure is not limited thereto, and various processes may be applied.

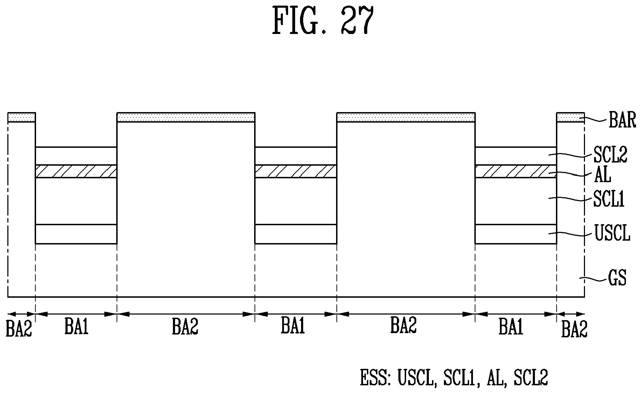

Hereinafter, a method of manufacturing the light emitting element LD in accordance with the second embodiment will be described with reference to FIGS. 17, and 27 to 30. FIGS. 27 to 30 are schematic views illustrating, by process steps, the method of manufacturing the light emitting element LD in accordance with the second embodiment. Description overlapping that of the embodiments described above will be simplified, or may not be repeated.

The method of manufacturing the light emitting element LD in accordance with the second embodiment may be different from the method of manufacturing the light emitting element LD in accordance with the first embodiment described above at least in that the barrier layer BAR disposed on the growth base GS may include material resistant to dry etching.

In the method of manufacturing the light emitting element LD in accordance with the second embodiment, the barrier layer BAR may include material such as titanium (Ti), which is resistant to the dry etching. For example, the barrier layer BAR may include material which is resistant to the dry etching. In the method of manufacturing the light emitting element LD in accordance with the second embodiment, semiconductor layers may not be formed in the second base area BA2.

For example, referring to FIGS. 17 and 27, at step S200 of forming the semiconductor layers, a semiconductor stack structure ESS may be formed in the first base area BA1 without forming the semiconductor layers on the barrier layer BAR in the second base area BA2.

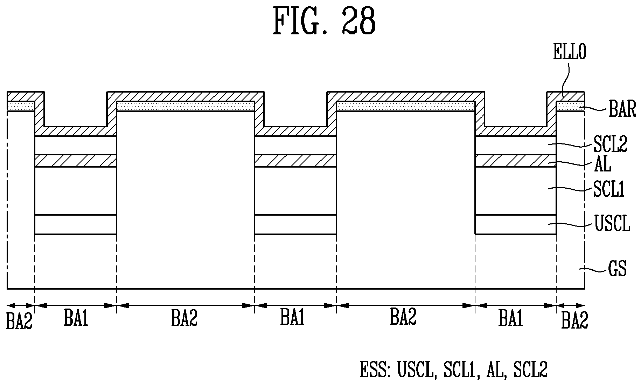

Referring to FIG. 28, a base electrode layer ELL0 may be formed in the first base area BA1 and the second base area BA2. The base electrode layer ELL0 may cover at least the barrier layer BAR.

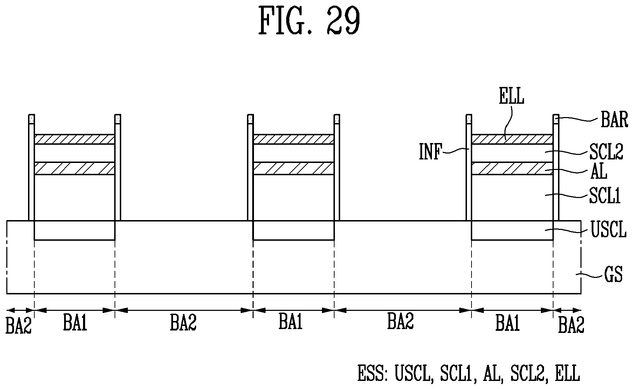

Referring to FIGS. 17 and 29, at step S300 of patterning a portion of the second base area of the growth base, at least a portion of the growth base GS may be removed.

For example, at least a portion of the growth base GS in the second base area BA2 may be etched, so that a portion of the growth base GS that remains in the second base area BA2 may form the insulating layer INF.

In an embodiment, because the barrier layer BAR may include material which is resistant to the etching, at least a portion of the barrier layer BAR may remain on the insulating layer INF after the present etching process is performed.

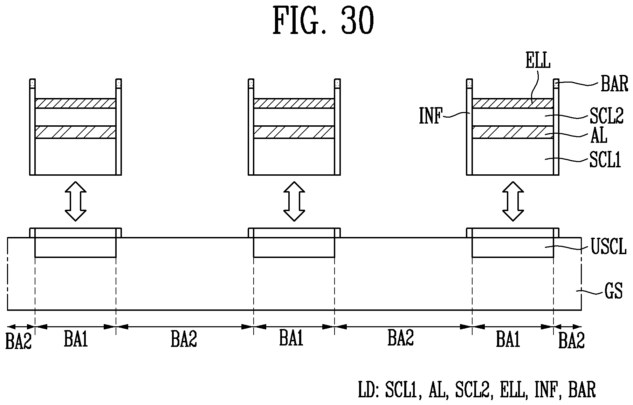

Referring to FIG. 17 and 30, at step S400 of separating the semiconductor stack structure, a portion of each of the first semiconductor layer SCL1 and the insulating layer INF may be cut, so that individually separated light emitting elements LD may be provided.

As described above, consequently, the light emitting element LD in accordance with the second embodiment may include a semiconductor stack structure ESS and an insulating layer INF, and may have a structure in which the barrier layer BAR is disposed on the insulating layer INF.

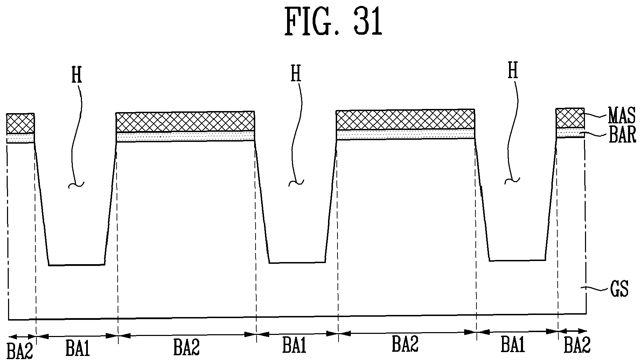

Hereinafter, a method of manufacturing the light emitting element LD in accordance with the third embodiment or the fourth embodiment will be described with reference to FIGS. 17, and 31 to 35. FIGS. 31 to 35 are schematic views illustrating, by process steps, the method of manufacturing the light emitting element LD in accordance with the third embodiment or the fourth embodiment. Description overlapping that of the embodiments described above will be simplified, or may not be repeated.

The method of manufacturing the light emitting element LD in accordance with the third embodiment or the fourth embodiment may be different from the method of manufacturing the light emitting element LD in accordance with the first embodiment described above at least in that an etching process for the first base area BA1 is performed such that an inner side surface of the growth base GS that is defined by holes H (e.g., that is adjacent to the holes H) has an inclined surface.

In the method of manufacturing the light emitting element LD in accordance with the third or fourth embodiment, the growth base GS in the first base area BA1 may be etched in such a way that, as the depth increases, a surface area of an etched portion thereof is reduced. The cross-sectional area of each of the holes H may be reduced as the depth increases.

For example, each of the holes H may have a truncated shape. For example, each of the holes H may have a truncated cone shape or a truncated polypyramid shape, depending on the cross-sectional shape thereof. For example, each of the holes H may have a truncated quadrangular pyramid shape or a truncated hexagonal pyramid shape. However, the disclosure is not limited to a specific example.

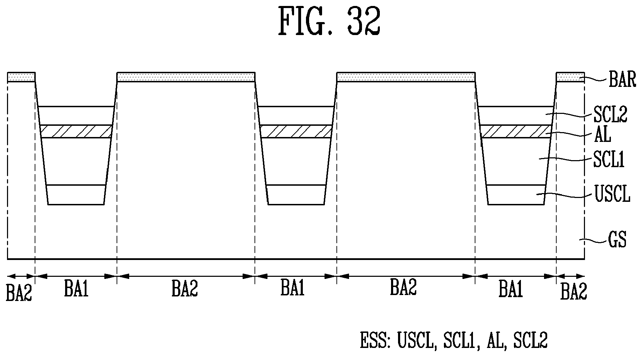

Referring to FIGS. 17 and 32, at step S200 of forming the semiconductor layers, the semiconductor layers may be successively formed in each of the holes H, so that a semiconductor stack structure ESS the cross-sectional area of which varies along the longitudinal direction may be formed.

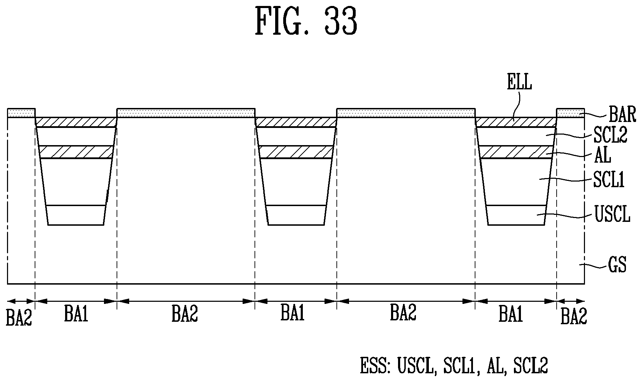

Thereafter, referring to FIG. 33, an electrode layer ELL may be patterned on the semiconductor stack structure ESS, so that the electrode layer ELL may be disposed on the second semiconductor layer SCL2 of each semiconductor stack structure ESS.

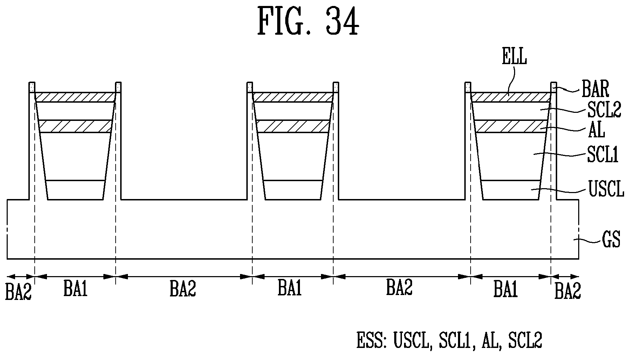

Referring to FIGS. 17 and 34, at step S300 of patterning a portion of the second base area of the growth base, at least a portion of the growth base GS may be removed.

For example, at least a portion of the growth base GS in the second base area BA2 may be etched, so that a portion of the growth base GS that remains in the second base area BA2 may form the insulating layer INF.

In an embodiment, because the direction in which the etching process is performed is different from the direction in which the side surface of the semiconductor stack structure ESS extends, the insulating layer INF may have a thickness which increases from the second semiconductor layer SCL2 toward the first semiconductor layer SCL1.

In an embodiment, the barrier layer BAR may include material which is resistant to the etching, at least a portion of the barrier layer BAR may remain on the insulating layer INF after the present etching process is performed. The light emitting element LD in accordance with the third embodiment may be manufactured.

In an embodiment, in the case where the barrier layer BAR may include material (e.g., indium tin oxide (ITO)) which is not resistant to the etching, the barrier layer BAR may be removed. The light emitting element LD in accordance with the fourth embodiment may be manufactured.

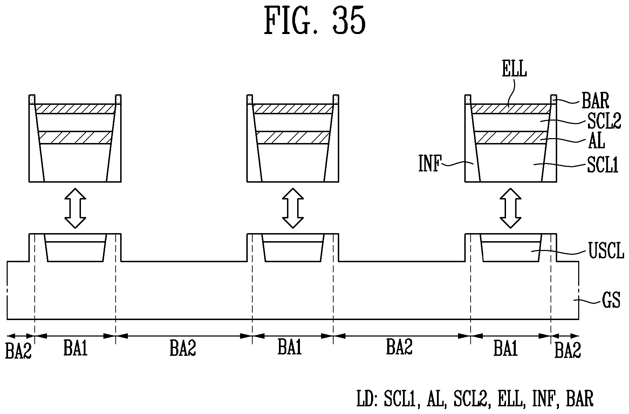

Referring to FIG. 17 and 35, at step S400 of separating the semiconductor stack structure, a portion of each of the first semiconductor layer SCL1 and the insulating layer INF may be cut, so that individually separated light emitting elements LD may be provided.

As described above, the light emitting element LD in accordance with the third embodiment or the fourth embodiment may include the semiconductor stack structure ESS and the insulating layer INF, and may be manufactured such that the semiconductor stack structure ESS has a structure in which a cross-sectional area thereof varies in the longitudinal direction (L) of the light emitting element LD.

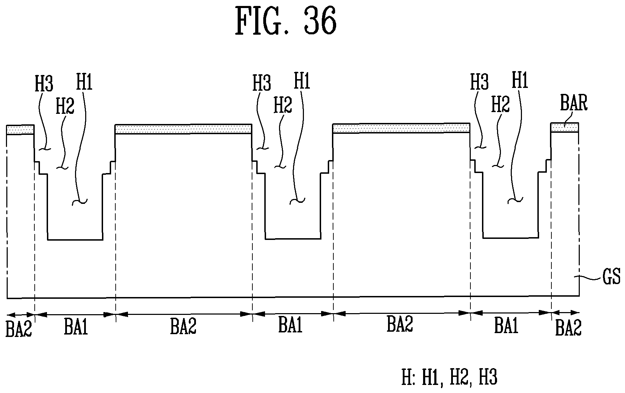

A method of manufacturing the light emitting element LD in accordance with the fifth embodiment or the sixth embodiment will be described with reference to FIGS. 17, and 36 to 40. FIGS. 36 to 40 are schematic views illustrating, by process steps, the method of manufacturing the light emitting element LD in accordance with the fifth embodiment or the sixth embodiment. Description overlapping that of the embodiments described above will be simplified, or may not be repeated.

The method of manufacturing the light emitting element LD in accordance with the fifth embodiment or the sixth embodiment may be different from the method of manufacturing the light emitting element LD in accordance with the first embodiment described above at least in that an etching process for the first base area BA1 is performed such that each of the holes H may include multiple areas having a step difference therebetween.

In the method of manufacturing the light emitting element LD in accordance with the fifth embodiment or the sixth embodiment, the growth base GS in the first base area BA1 may be etched to have a step difference in such a way that a surface area of an etched portion thereof is reduced as the depth increases.

Referring to FIGS. 17 and 36, at step S100 of patterning the first base area of the growth base, the holes H may include a first hole H1, a second hole H2, and a third hole H3 which are fluidly connected to each other. Each of the first hole H1, the second hole H2, and the third hole H3 may have a uniform cross-sectional area.

The first hole H1, the second hole H2, and the third hole H3 may have different sizes, and may have a corresponding shape. Here, the corresponding shape may be a pillar shape extending in a direction. However, the disclosure is not limited to a specific example.

In an embodiment, the cross-sectional area of the second hole H2 may be greater than that of the first hole H1, and may be less than that of the third hole H3. Hence, the hole H may have an approximately T shape.

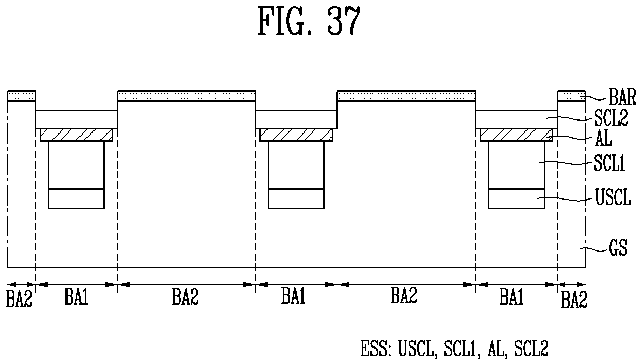

Referring to FIGS. 17 and 37, at step S200 of forming semiconductor layers, the semiconductor layers may be successively formed in the holes H. In an embodiment, the first semiconductor layer SCL1 may be formed in the first hole H1, the active layer AL may be formed in the second hole H2, and the second semiconductor layer SCL2 may be formed in the third hole H3.

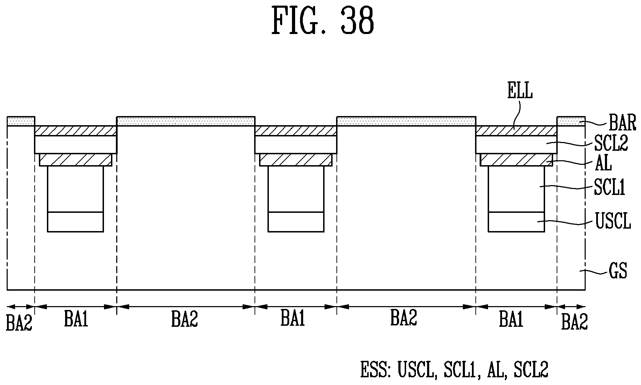

Thereafter, referring to FIG. 38, an electrode layer ELL may be patterned on the semiconductor stack structure ESS, so that the electrode layer ELL may be disposed on the second semiconductor layer SCL2 of each semiconductor stack structure ESS.

Referring to FIGS. 17 to 39, at step S300 of patterning a portion of the second base area of the growth base, at least a portion of the growth base GS may be removed.

For example, at least a portion of the growth base GS in the second base area BA2 may be etched, so that a portion of the growth base GS that remains in the second base area BA2 may form the insulating layer INF.

In an embodiment, the direction in which the etching process is performed is the same as the direction in which the side surface of each semiconductor layers in the semiconductor stack structure ESS extends, and the respective cross-sectional areas of the first semiconductor layer SCL1, the active layer AL, and the second semiconductor layer SCL2 are different from each other, so that the insulating layer INF formed complementary thereto may have different thicknesses at positions respectively corresponding to the first semiconductor layer SCL1, the active layer AL, and the second semiconductor layer SCL2.

In an embodiment, the barrier layer BAR may include material which is resistant to the etching, and at least a portion of the barrier layer BAR may remain on the insulating layer INF after the present etching process is performed. The light emitting element LD in accordance with the fifth embodiment may be manufactured.

In an embodiment, in the case where the barrier layer BAR includes material {e.g., indium tin oxide (ITO)} which is not resistant to the etching, the barrier layer BAR may be removed. The light emitting element LD in accordance with the sixth embodiment may be manufactured.

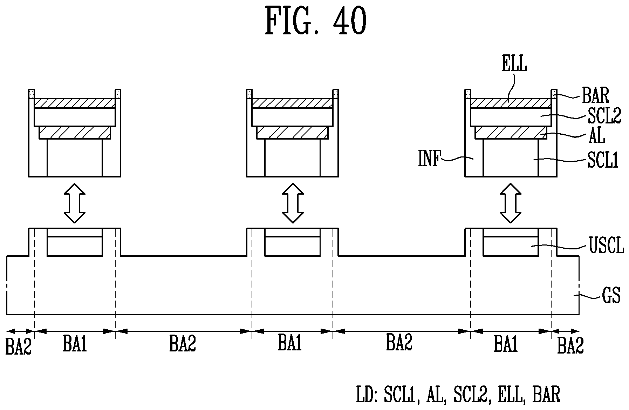

Referring to FIG. 17 and 40, at step S400 of separating the semiconductor stack structure, a portion of each of the first semiconductor layer SCL1 and the insulating layer INF may be cut, so that individually separated light emitting elements LD may be provided.

As described above, the light emitting element LD in accordance with the fifth embodiment or the sixth embodiment may include the semiconductor stack structure ESS and the insulating layer INF, and may be manufactured such that the semiconductor stack structure ESS has a structure in which a cross-sectional area thereof varies in the longitudinal direction (L) of the light emitting element LD.

Next, the method of manufacturing the light emitting elements LD in accordance with the seventh embodiment will be described with reference to FIGS. 41 to 49. Description overlapping that of the embodiments described above will be simplified, or may not be repeated.

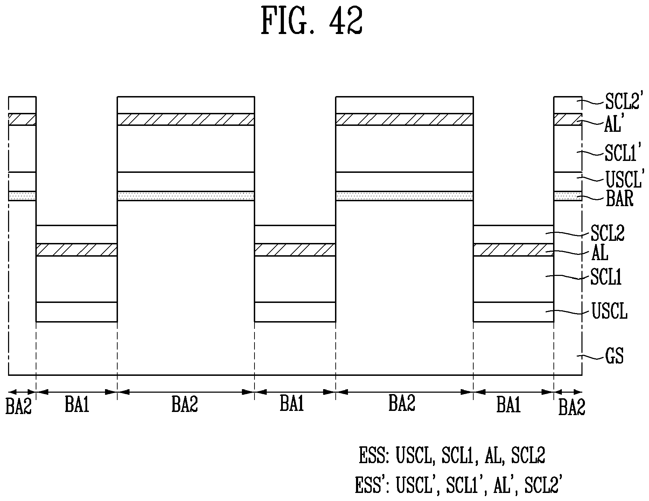

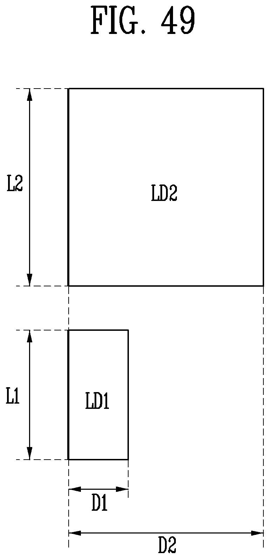

FIGS. 41 to 48 are views illustrating the method of manufacturing light emitting elements in accordance with the seventh embodiment. FIG. 41 is a flowchart illustrating the method of manufacturing the light emitting elements in accordance with the seventh embodiment. FIGS. 42 to 48 are schematic views illustrating, by process steps, the method of manufacturing the light emitting element LD in accordance with the seventh embodiment. FIG. 49 is a schematic view for comparing sizes of a first light emitting element and a second light emitting element to each other in accordance with an embodiment. Description overlapping that of the embodiments described above will be simplified, or may not be repeated.

Referring to FIG. 41, the method of manufacturing the light emitting element in accordance with the seventh embodiment may include step S1000 of patterning a first base area of the growth base, step S2000 of forming semiconductor layers, step S3000 of forming an upper insulating layer, step S4000 of forming an electrode layer, step S5000 of separating an upper semiconductor stack structure, step S6000 of patterning a portion of a second base area of the growth base, and step S7000 of separating a semiconductor stack structure.

Referring to FIGS. 41 and 42, to perform the method of manufacturing the light emitting element in accordance with the seventh embodiment, step S1000 of patterning the first base area of the growth base may be performed. For example, a pattern corresponding to the shape of the semiconductor stack structure ESS of the light emitting element LD to be manufactured may be formed by patterning a portion of the growth base GS. Thereafter, step S2000 of forming semiconductor layers may be performed, so that the semiconductor stack structure ESS may be formed in the first base area BA1, and the upper semiconductor stack structure ESS' may be formed on the growth base GS in the second base area BA2.

For example, semiconductor layers may be grown in a recess formed by patterning the growth base GS, so that the semiconductor stack structure may be manufactured. Semiconductor layers may be grown on a protrusion that is an un-patterned portion of the growth base GS, so that the upper semiconductor stack structure ESS' may be manufactured. In an embodiment, the upper semiconductor stack structure ESS' may include an upper undoped semiconductor layer USCL', a first upper semiconductor layer SCL1', an upper active layer AL', and a second upper semiconductor layer SCL2'.

In a manner similar to that described above, because an individual semiconductor stack structure ESS may be formed without performing a process of directly etching the semiconductor stack structure ESS, the structural stability of the semiconductor stack structure ESS may be enhanced, so that the emission efficiency of the light emitting element LD can be improved.

Referring to FIGS. 41, 43, and 44, at step S3000 of forming the upper insulating layer, an upper base insulating layer INFO' may be formed (or deposited) to cover the upper semiconductor stack structure ESS', and an outer insulating layer OINF and an inner insulating layer INF' may be formed by etching the upper base insulating layer INFO'.

For example, the upper base insulating layer INFO' may be formed in the first base area BA1 and the second base area BA2. Hence, a portion of the upper base insulating layer INFO' may be disposed on the upper semiconductor stack structure ESS', and another portion of the upper base insulating layer INFO' may be disposed on the semiconductor stack structure ESS. In an embodiment, the upper base insulating layer INFO' may cover a side surface of the upper semiconductor stack structure ESS'.

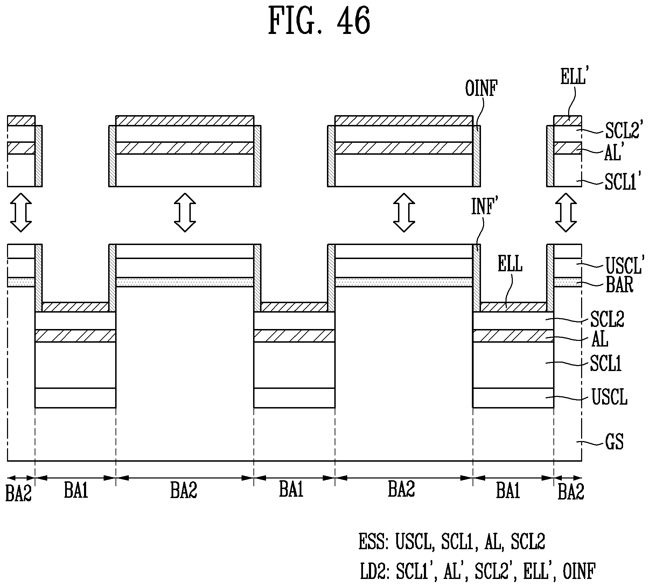

The upper base insulating layer INFO' may form an outer insulating layer OINF of a second light emitting element LD2 (refer to FIG. 46) including the upper semiconductor stack structure ESS'. The upper base insulating layer INFO' may form an inner insulating layer INF' of the light emitting element LD in accordance with the seventh embodiment. In an embodiment, the upper base insulating layer INFO' may have an amorphous structure. Hence, the inner insulating layer INF' of the light emitting element LD in accordance with the seventh embodiment may have an amorphous structure.

Although not shown in the drawings, the upper base insulating layer INFO' may be formed after an additional etching process for patterning the upper semiconductor stack structure ESS' is performed, depending on the embodiment. For example, the cross-sectional shape and the size of the upper semiconductor stack structure ESS' may be determined by performing the additional etching process.

In the present phase, the upper base insulating layer INFO' may be etched, so that an upper surface of the upper semiconductor stack structure ESS' may be exposed, and an upper surface of the semiconductor stack structure ESS may be exposed.

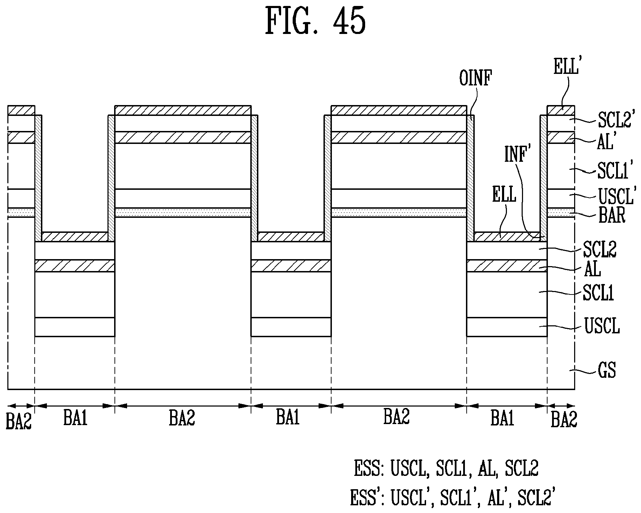

Referring to FIGS. 41 and 45, at step S4000 of forming an electrode layer, an electrode layer ELL may be formed on the semiconductor stack structure ESS in the first base area BA1, and an upper electrode layer ELL' may be formed on the upper semiconductor stack structure ESS' in the second base area BA2.

In the present phase, the electrode layers ELL and ELL' may be patterned. Some of the electrode layers ELL and ELL' may be disposed in the first base area BA1 and electrically connected to the semiconductor stack structure ESS, and others of the electrode layers ELL and ELL' may be disposed in the second base area BA2 and electrically connected to the upper semiconductor stack structure ESS'.

Referring to FIGS. 41 and 46, at step S5000 of separating the upper semiconductor stack structure, the upper semiconductor stack structure ESS' and the external insulating layer OINF are separated, so that the second light emitting element LD2 may be manufactured.

The second light emitting elements LD2 may be individually separated elements, based on the semiconductor layers that are grown on the portion of the growth base GS that overlap the second base area BA2. In an embodiment, because not only the light emitting elements LD can be manufactured in the first base area BA1 which is an etched area of the growth base GS but the second light emitting elements LD2 can also be manufactured in the second base area BA2 which is a non-etched area of the growth base GS, the structures of the growth base GS may be optimally used, so that the processing cost may be markedly reduced.

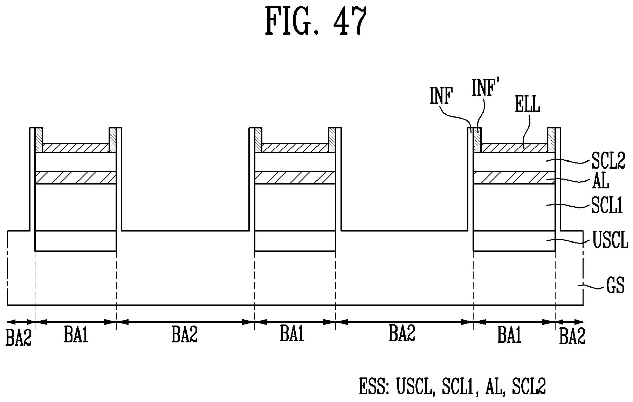

Referring to FIGS. 41 and 47, step S6000 of patterning a portion of the second base area of the growth base may be performed, so that at least a portion of the growth base GS may be manufactured into the insulating layer INF.

For example, at the present phase, lower structures of the separated second light emitting elements LD2 may be removed, and semiconductor stack structures ESS may be manufactured to be spaced apart from each other.

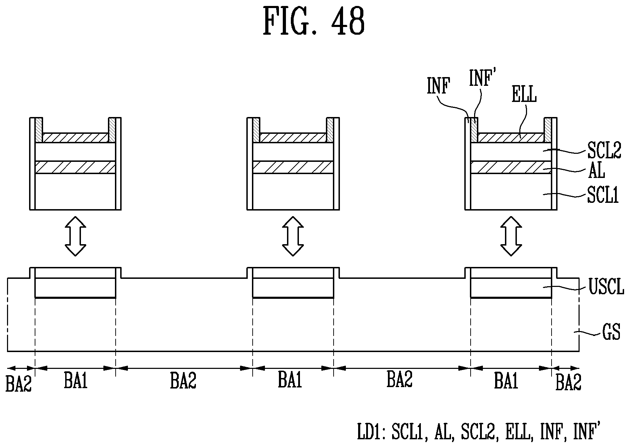

Referring to FIGS. 41 and 48, at step S7000 of separating the semiconductor stack structure, the semiconductor stack structure ESS, the insulating layer INF, and the inner insulating layer INF' may be separated, so that the light emitting element LD (e.g., the first light emitting element LD1) in accordance with the seventh embodiment can be manufactured.

Referring to FIG. 49, the first light emitting element LD1 may have a size smaller than that of the second light emitting element LD2. For example, a first diameter D1 of the first light emitting element LD1 may be less than a second diameter D2 of the second light emitting element LD2. For example, a first length L1 of the first light emitting element LD1 may be less than a second length L2 of the second light emitting element LD2.

In an embodiment, the first light emitting element LD1 which may be individually patterned without performing an etching process for the semiconductor layers may have a relatively small size, and the second light emitting element LD2 which may be formed through an etching process for the semiconductor layers may have a relatively large size. The sizes of the light emitting elements LD1 and LD2 may be determined depending on whether the etching process for the semiconductor layers is present, so that the process may be optimized.

Various embodiments of the disclosure provide a light emitting element which is improved in emission efficiency and reliability, a method of manufacturing the light emitting element, and a display device comprising the light emitting element.

Various embodiments of the disclosure provide a light emitting element capable of preventing a risk from occurring during a manufacturing process, a method of manufacturing the light emitting element, and a display device comprising the light emitting element.

While various embodiments have been described above, those skilled in the art will appreciate that various modifications, additions and substitutions are possible, without departing from the scope of the disclosure.

Therefore, the embodiments disclosed in this specification are only for illustrative purposes rather than limiting the disclosure.

## Claims

1. A method of manufacturing a light emitting element, comprising:
patterning a first base area of a growth base;
forming semiconductor layers; and
patterning a portion of a second base area of the growth base, different from the first base area.

2. The method according to claim 1, further comprising:
forming an insulating layer to be included in the light emitting element,
wherein
the insulating layer and the growth base comprise a same material, and
the growth base and the insulating layer comprise at least one of aluminium oxide and a silicon-based material.

3. The method according to claim 2, wherein
the patterning of the first base area comprises:
forming a barrier layer and a mask on the growth base; and
exposing the growth base from the mask, and
the first base area and a non-disposition area in which the mask is not disposed overlap each other in a plan view.

4. The method according to claim 3, wherein:
(i) the patterning of the portion of the second base area comprises removing the barrier layer; or
(ii) the patterning of the portion of the second base area comprises forming the barrier layer on the insulating layer by allowing at least a portion of the barrier layer to remain.

5. The method according to any one of claims 1 to 4, wherein
the patterning of the first base area comprises forming a hole in the growth base, and
a shape of the hole corresponds to a shape of a semiconductor stack structure provided to form the light emitting element manufactured by the method.

6. The method according to claim 5, wherein:
(i) the hole has a constant cross-sectional area in a longitudinal direction; or
(ii) the patterning of the first base area comprises etching the growth base such that an inner side surface of the growth base that is defined by the hole has an inclined surface; or
(iii) the forming of the hole comprises:
forming a first hole;
forming a second hole; and
forming a third hole,
each of the first hole, the second hole, and the third hole has a uniform cross-sectional area,
the cross-sectional area of the second hole is greater than the cross-sectional area of the first hole, and
the cross-sectional area of the second hole is less than the cross-sectional area of the third hole.

7. The method according to any one of claims 1 to 6, wherein
the semiconductor layers comprise a semiconductor stack structure comprising:
a first semiconductor layer;
an active layer; and
a second semiconductor layer, and
the forming of the semiconductor layers comprises passivating an outer surface of the semiconductor stack structure,
the semiconductor layers comprise:
a semiconductor stack structure overlapping the first base area in a plan view and comprising:
a first semiconductor layer;
an active layer; and
a second semiconductor layer; and
an upper semiconductor stack structure overlapping the second base area in a plan view and comprising:
a first upper semiconductor layer;
an upper active layer; and
a second upper semiconductor layer,
the forming of the semiconductor layers comprises forming an active layer comprising a well layer and a barrier layer, and
the forming of the active layer comprises forming the active layer such that the well layer and the barrier layer comprise a quantum particle, and
the method further comprises:
forming an electrode layer on the first base area and the second base area after forming the semiconductor layers.

8. The method according to any one of claims 1 to 7, wherein the patterning of the portion of the second base area comprises etching a portion of the second base area without performing an etching process for the first base area,
the etching of the portion of the second base area comprises allowing at least a portion of the second base area to remain and be provided as an insulating layer,
the semiconductor layers comprise:
a first semiconductor layer;
an active layer; and
a second semiconductor layer,
the active layer comprises a quantum well structure comprising a quantum particle, and
an etching range in which etching the portion of the second base area is performed does not overlap the quantum particle in an etching direction.

9. A light emitting element, comprising:
a semiconductor stack structure comprising:
a first semiconductor layer;
a second semiconductor layer; and
an active layer disposed between the first semiconductor layer and the second semiconductor layer; and
an insulating layer disposed on at least one side surface of the semiconductor stack structure,
wherein the insulating layer comprises a crystalline structure.

10. The light emitting element according to claim 9, wherein:
(i) the active layer comprises a three-dimensional quantum well structure comprising a quantum particle, and
the active layer comprises a well layer and a barrier layer and does not include a defect corresponding to a size of the quantum particle; and/or
(ii) the insulating layer comprises at least one of aluminium oxide and a silicon-based material.

11. The light emitting element according to claim 9 or claim 10, wherein the insulating layer comprises:
an insulating protrusion protruding in a longitudinal direction of the light emitting element, and enclosing space on one end of the semiconductor stack structure.

12. The light emitting element according to any one of claims 9 to 11, further comprising:
a barrier layer disposed on the insulating layer and comprising a conductive material.

13. The light emitting element according to any one of claims 9 to 12, wherein
the light emitting element comprises:
a first end adjacent to the first semiconductor layer; and
a second end adjacent to the second semiconductor layer, and
a thickness of the insulating layer is reduced from the first end toward the second end, and
a cross-sectional area of the semiconductor stack structure is increased from the first end toward the second end, optionally wherein:
the thickness of the insulating layer is formed complementary to the cross-sectional area of the semiconductor stack structure, so that a cross-sectional area of the light emitting element is uniform in a longitudinal direction of the light emitting element.

14. The light emitting element according to claim 10, wherein
each of the active layer, the first semiconductor layer, and the second semiconductor layer has a cross-sectional area,
the cross-sectional area of the active layer is greater than the cross-sectional area of the first semiconductor layer,
the cross-sectional area of the active layer is less than the cross-sectional area of the second semiconductor layer,
the active layer comprises:
a first active surface facing the first semiconductor layer; and
a second active surface facing the second semiconductor layer,
the first active surface comprises:
a contact area which contacts the first semiconductor layer; and
a non-contact area which does not contact the first semiconductor layer, and
the second active surface entirely contacts the second semiconductor layer.

15. The light emitting element according to any one of claims 9 to 11, wherein the insulating layer comprises:
a first insulating layer comprising a crystalline structure and disposed on a side surface of the semiconductor stack structure; and
a second insulating layer comprising an amorphous structure and disposed on a first end of the semiconductor stack structure.

16. A method of manufacturing a light emitting element, comprising:
patterning a first base area of a growth base, the growth base comprising the first base area and a second base area;
forming semiconductor layers comprising a semiconductor stack structure and an upper semiconductor stack structure;
forming an upper insulating layer;
separating the upper semiconductor stack structure that overlaps the second base area in a plan view;
patterning the second base area of the growth base; and
separating the semiconductor stack structure that overlaps the first base area in the plan view to provide the light emitting element.

17. The method according to claim 16, wherein:
(i) the method further comprises:
forming an insulating layer to be included in the light emitting element provided by performing the separating of the semiconductor stack structure, wherein
the insulating layer and the growth base comprise a same material,
the patterning of the first base area comprises forming holes in the growth base, and
a shape of each of the holes corresponds to a shape of the light emitting element; and/or
(ii) the upper semiconductor stack structure overlaps the second base area in a plan view,
the semiconductor stack structure overlaps the first base area in a plan view,
the upper insulating layer comprises:
an outer insulating layer covering a side surface of the upper semiconductor stack structure; and
an inner insulating layer disposed on at least one surface of the semiconductor stack structure, and
the upper insulating layer comprises an amorphous structure.

18. The method according to claim 16 or claim 17, further comprising:
etching the upper semiconductor stack structure after the forming of the semiconductor layers,
wherein
the separating of the semiconductor stack structure comprises providing a first light emitting element, and
the separating of the upper semiconductor stack structure comprises providing a second light emitting element, optionally wherein a size of the first light emitting element is less than a size of the second light emitting element.
